Europäisches Patentamt

European Patent Office

Office européen des brevets

(19)

(11) Numéro de publication: **0 224 315**
**B1**

(12) **FASCICULE DE BREVET EUROPEEN**

(45) Date de publication du fascicule du brevet: **02.05.90**

(51) Int. Cl.⁵: **H 03 D 3/00, G 01 S 1/50**

(21) Numéro de dépôt: **86202093.0**

(22) Date de dépôt: **25.11.86**

(54) **Discriminateur numérique de fréquence, et application à un signal composite VOR.**

(30) Priorité: **29.11.85 FR 8517684**

(43) Date de publication de la demande:
**03.06.87 Bulletin 87/23**

(45) Mention de la délivrance du brevet:
**02.05.90 Bulletin 90/18**

(84) Etats contractants désignés:
**DE FR GB**

(56) Documents cités:
**EP-A-0 029 376**
**EP-A-0 107 884**
**US-A-4 074 267**

**DIGITAL SIGNAL PROCESSING, 1984, éditor V. Capellini et al., pages 632-637, Elsevier Science Publishers B.V., North-Holland, NL; HAFEZ SALAH et al.: "The performance of radio altitmeter with digital discriminator"**

(73) Titulaire: **TELECOMMUNICATIONS RADIOELECTRIQUES ET TELEPHONIQUES T.R.T.**
**88, rue Brillat Savarin**
**F-75013 Paris (FR)**
(84) **FR**

(73) Titulaire: **N.V. Philips' Gloeilampenfabrieken**
**Groenewoudseweg 1**
**NL-5621 BA Eindhoven (NL)**
(84) **DE GB**

(72) Inventeur: **Hethuin, Serge Société Civile S.P.I.D.**
**209, rue de l'Université**
**F-75007 Paris (FR)**

(74) Mandataire: **Pyronnet, Jacques et al**
**Société Civile S.P.I.D. 209 rue de l'Université**
**F-75007 Paris (FR)**

**Description**

La présente invention concerne un discriminateur numérique de fréquence destiné à extraire d'une porteuse à la fréquence $f_o$ au moins un signal sinusoïdal basse fréquence, de fréquence F, modulant en fréquence ladite porteuse avec une excursion de fréquence modulante $\Delta F$, les valeurs de $f_o$ et $\Delta F$ étant connues.

Le discriminateur selon l'invention s'applique particulièrement à la recherche de la phase dite de référence contenue dans le signal composite VOR, reçu par un équipement de bord VOR-ILS, par reconstitution point par point du signal sinusoïdal à 30 Hz donnant la phase de référence.

La plupart des discriminateurs de fréquence utilisés à ce jour sont des discriminateurs analogiques. Ils sont utilisés notamment en radionavigation. Par exemple, dans un radioaltimètre du type à onde continue modulée linéairement en fréquence, il est connu de maintenir à une fréquence de consigne $f_{bo}$ constante de valeur prédéterminée la fréquence $f_b$ du signal de battement soustractif entre onde émise et onde réfléchie reçue en introduisant un tel discriminateur dans la chaîne de contre réaction qui commande la pente de la droite de modulation du signal émis. Ce discriminateur qui a pour fonction de fournir, selon une caractéristique sensiblement linéaire, l'écart entre la fréquence $f_b$ et la fréquence de consigne, se compose pour l'essentiel de deux chaînes de traitement qui reçoivent chacune le signal à discriminer. Chaque chaîne de traitement comporte un filtre passe bande, centré sur $f_{bo} - \delta f$ (respectivement centré sur $f_{bo} + \delta f$), suivi d'un détecteur de valeur absolue. Les deux signaux ainsi obtenus sont soustraits l'un de l'autre et le signal résultant est filtré à travers un filtre passe bas. On obtient ainsi une courbe caractéristique amplitude-fréquence en S dont la partie centrale, de part et d'autre d'un déphasage égal à $\Pi/2$, est sensiblement linéaire. De l'ouvrage "Digital Signal Processing" par V. Capellini et A. G. Constantini, publié par Elsevier Science Publishers B.V. (North Holland 1984), pages 632 à 637, il est connu de transposer en numérique la structure du discriminateur analogique décrit ci-dessus. Les six éléments qui composant cette structure sont ainsi réalisés en numérique, ce qui procure certains avantages tels que la facilité de réglage lors de la production en série par exemple. On obtient ainsi à nouveau la courbe caractéristique en S précitée. Ce discriminateur numérique présente des inconvénients: sa linéarité est limitée. D'autre part, le filtrage ainsi réalisé requiert un volume de calcul important et le résultat obtenu, s'il est acceptable pour un spectre de fréquence continu présentant un front avant que l'on cherche à discriminer comme c'est le cas pour le signal de battement d'un radioaltimètre, est moins performant lorsqu'on cherche à faire la discrimination d'une seule raie de fréquence, par exemple par démodulation d'un signal VOR-ILS. (Voir aussi le document EP—A—0 029 376 qui divulge un procédé de démodulation numérique d'un signal modulé en fréquence dans lequel le signal à démoduler est échantillonné suivant une fréquence 4 F', F' étant une fréquence située dans la bande de fréquence du signal).

L'invention a pour but d'élaborer un discriminateur numérique permettant de reconstituer, à l'aide d'un processus numérique, au moins un signal basse fréquence transmis sur une porteuse en modulation de fréquence.

Un autre but de l'invention est de réaliser un discriminateur numérique présentant une excellente linéarité.

Encore un autre but de l'invention est de réduire le volume de calculs effectués par le discriminateur numérique.

Ces buts sont atteints grâce au fait que le discriminateur numérique selon l'invention est remarquable en ce qu'il reçoit, avec ou sans préfiltrage, des échantillons numériques $x_n$ de ladite porteuse modulée à une fréquence $f_e$ telle que: $f_e = 4\,f_o$, et qu'il comporte:

des moyens d'accumulation pour accumuler entre deux dates successives $t_q$ et $t_{q+1}$ un nombre paramétrable de N échantillons numériques $x_n$ successifs qui constituent une fenêtre d'analyse,

des premiers moyens de stockage pour stocker des coefficients $R_{01}$, $R_{02}$, $R_{11}$, $R_{12}$, $R_{22}$ définis par:

$$R_{01} = \sum_{n=0}^{N-1} x_n \cdot x_{n-1}$$

$$R_{02} = \sum_{n=0}^{N-1} x_n \cdot x_{n-2}$$

$$R_{11} = \sum_{n=0}^{N-1} x^2_{n-1}$$

$$R_{12} = \sum_{n=0}^{N-1} x_{n-1} \cdot x_{n-2}$$

$$R_{22} = \sum_{n=0}^{N-1} x^2_{n-2}$$

des moyens de formatage desdits coefficients,
des premiers moyens de calcul de la quantité $a_1$ définie par:

$$a_1 = \frac{R_{02} R_{12} - R_{01} R_{22}}{R_{11} R_{22} - R^2_{12}},$$

la quantité $a_1$ étant assimilable, à un coefficient multiplicatif près, à l'ordonnée d'un point de la courbe représentative dudit signal sinusoïdal basse fréquence cherché et que la valeur de $a_1$ est transférée dans des deuxièmes moyens de stockage, après quoi le point suivant dudit signal sinusoïdal basse fréquence est déterminé à partir des N échantillons qui suivent la date $t_{q+1}$.

Les calculs effectués pour reconstituer point par point ledit signal sinusoïdal basse fréquence résultent d'un choix de modèle mathématique simple d'ordre 2 et d'hypothèses simplificatrices expliquées en détail plus loin. Le formatage des coefficients a pour but d'examiner, pour chaque point reconstitué, si les coefficients $R_{01}$, $R_{02}$, $R_{11}$, $R_{12}$, $R_{22}$ ont une valeur suffisamment grande pour que la détermination du point considéré puisse être déclarée valide et, dans l'affirmative, de faciliter les calculs ultérieurs effectués sur ces coefficients pour la détermination de la quantité $a_1$.

Un mode de réalisation préféré du discriminateur selon l'invention est remarquable en ce qu'il comporte en outre des deuxièmes moyens de calcul de la quantité $a_2$ définie par:

$$a_2 = \frac{R_{01} R_{12} - R_{02} R_{11}}{R_{11} R_{22} - R_{12}^2},$$

la quantité $a_2$ étant utilisée comme indicateur de la convergence et qu'à cet effet ledit discriminateur numérique de fréquence comporte des moyens de comparaison de la quantité $a_2$ à deux seuils $s_1$ et $s_2$ de valeur paramétrable telle que la quantité $a_1$ n'est validée et transférée dans lesdits deuxièmes moyens de stockage que si: $s_1 < a_2 < s_2$.

La valeur à donner à $s_1$ et $s_2$ dépend de l'amplitude du signal utile à traiter. Dans le cas le plus fréquent, il s'agit d'un signal Hertzien bruité et, en dessous d'une certaine valeur du rapport signal/bruit, on est amené à considérer que la discrimination d'un signal basse fréquence n'est plus possible. La détermination des seuils $s_1$ et $s_2$ résulte donc du test de l'appareillage en dépendance de la puissance du signal utile reçu et de la puissance de bruit mélangée à ce signal.

Une application particulièrement intéressante du discriminateur selon l'invention à un signal VOR comme indiqué au paragraphe 2 du présent exposé se caractérise par une fréquence d'échantillonnage, égale à 13280 Hz, appliquée à une porteuse à 3320 Hz obtenue du fait de filtrer la porteuse à 9960 Hz du signal VOR à travers un filtre antirepliement analogique d'ordre inférieur ou égal à trois dont la bande passante est comprise entre 0 et 10600 Hz et dont la bande de transition s'étend entre 10600 Hz et 15960 Hz, d'échantillonner à la fréquence 26560 Hz le signal obtenu en sortie du filtre antirepliement et de filtrer les échantillons à travers un filtre demi-bande à 4 coefficients distincts dont la sortie passe haut est reliée à l'entrée dudit discriminateur numérique.

En abaissant ainsi la fréquence d'échantillonnage du fait de réduire à un tiers de sa valeur la fréquence de la porteuse, on abaisse en conséquence la charge de calcul que doit effectuer le discriminateur numérique.

La description qui suit en regard des dessins annexés, le tout donné à titre d'exemple, fera bien comprendre comment l'invention peut être réalisée.

La figure 1 est un schéma synoptique de la chaîne de traitement du signal qui incorpore le discriminateur numérique selon l'invention.

La figure 2 représente des courbes de la variance d'estimation en fonction du rapport signal/bruit des valeurs des échantillons de sortie du discriminateur pour différentes fenêtres d'analyse et selon qu'on introduit ou non un préfiltrage.

La figure 3 représente le spectre d'un signal composite VOR.

Les figures 4 et 5 représentent chacune une chaîne de traitement utilisable pour un signal analogique VOR, jusqu'à la production des échantillons d'entrée $e_n$ de la figure 1.

La figure 6 représente un filtre numérique séparateur de bandes utilisé de préférence dans la chaîne de traitement de la figure 5.

La figure 7 est l'ordinogramme général explicitant le fonctionnement du discriminateur selon l'invention.

Les figures 8a et 8b constituent un ordinogramme détaillé explicitant le fonctionnement du discriminateur selon l'invention.

La figure 9 est l'ordinogramme du calcul de l'élément de la suite $v_q$ associée à la suite $y_q$.

Le problème technique précis à résoudre consiste à retrouver, à l'aide d'un procédé numérique, un signal basse fréquence $y(t)$ de fréquence F transmis en modulation de fréquence sur une porteuse à la fréquence $f_o$. Le signal modulant basse fréquence s'écrit de façon simplifiée:

$$y(t) = a \sin(\omega t + \varphi) \qquad (1)$$

formule dans laquelle:

a est l'amplitude,

$\omega = 2\Pi F$ est la pulsation

$\varphi$ est la phase à l'origine.

Sous la forme discrète à l'instant d'échantillonnage i, la formule (1) peut s'écrire:

$$y_i = a \sin(2\Pi \frac{F}{f_e} i + \varphi)$$

$f_e$ étant la fréquence d'échantillonnage, inverse de la période d'échantillonnage $\Delta T$.

La modulation de fréquence effectuée sur la porteuse avec une excursion de fréquence $\Delta F$ par $y(t)$ se caractérise comme suit: la fréquence instantanée de la porteuse modulée $f_{in}$ s'écrit:

$f_{in} = f_o + \Delta F\, y(t)$

ou encore, sous forme numérique:

$$f_n = f_o + \Delta F\, y_n \qquad (2)$$

La phase à l'instant t, $\emptyset(t)$ vaut donc:

$$\emptyset = 2\Pi\, f_o t + 2\Pi\, \Delta F \int_0^t y(u)\,du$$

ce qui peut s'écrire sous forme discrète à l'instant d'échantillonnage n:

$$\emptyset_n = 2\Pi\left(\frac{f_o}{f_e} n + \frac{\Delta F}{f_e} \sum_{i=0}^{n} y_i\right)$$

4

On notera que la phase à l'instant n est reliée à celle à l'instant (n-1) par une relation simple:

$$\emptyset_n = \emptyset_{n-1} + \frac{2\pi}{f_e} f_n$$

L'expression de la porteuse modulée en fréquence est alors:

$$z(t) = b \sin\{2\Pi(f_0 t + \Delta F \int_0^t y(u)du) + \alpha\}$$

ou bien, si ce signal est codé sous forme numérique:

$$z_n = b \sin\{2\Pi(\frac{f_0}{f_e} n + \frac{\Delta F}{f_e} \sum_{i=0}^{n} y_i) + \alpha\} \tag{3}$$

où b est l'amplitude, et α la phase à l'origine.

On s'intéresse à restituer les $y_n$ successifs, c'est-à-dire le signal de modulation. L'hypothèse de base du procédé de traitement numérique de signal exposé ci-dessous consiste à faire l'approximation que la fréquence instantanée $f_n$ (voir formule 2) ne varie pas sur un intervalle de temps court par rapport à: T = 1/F. Autrement dit, la fréquence $f_n$ pour n tel que: $N_o - N/2 \leq n \leq N_o + N/2$ est, en première approximation, égale à une constante f si N est petit. Dans ces conditions, le problème posé se résume à l'estimation point par point d'une sinusoïde. Soit donc f la valeur de fréquence à estimer et soit $\Omega = 2\Pi f \Delta T$ la pseudo-pulsation associée; on peut écrire, en première approximation:

$$z_n = b \sin(n\Omega + \alpha), \tag{4}$$

du fait de remplacer

$$\sum_{i=0}^{n} y_i \text{ par } n \; y_n.$$

En vertu de la formule trigonométrique:

$$\sin p + \sin q = 2 \sin(\frac{p+q}{2}) \cos(\frac{p-q}{2})$$

avec: $p = n\Omega + \alpha$ et $q = (n-2)\Omega + \alpha$, il vient:
$\sin(n\Omega + \alpha) + \sin[(n-2)\Omega + \alpha] = 2 \cos\Omega \sin[(n-1)\Omega + \alpha]$ soit encore:

$$z_n + z_{n-2} = 2 \cos\Omega \; z_{n-1} \tag{5}$$

Les signaux sont reçus dans un environnement bruité et le problème consiste à déterminer $\Omega$, et par suite $y_n$ en vertu de la formule (2), dans des conditions de rapport signal à bruit S/B extrêmement variables, ce rapport S/B variant de 50 dB à 0 dB par exemple, à partir des simples observations. Pour cela, on considère que chaque échantillon est bruité et l'on obtient donc, à l'instant $n\Delta T$:

$z_n + b_n = x_n$

$x_n$ étant l'échantillon numérique du signal d'entrée du discriminateur et $b_n$ la quantité de bruit associée à cet échantillon; il vient:

$z_n = x_n - b_n$

La relation (5) s'écrit alors:

$$x_n + x_{n-2} = 2 \cos\Omega \; x_{n-1} + \varepsilon_n \tag{6}$$

ou plus précisément:

$$x_n + \rho^2 x_{n-2} = 2\rho \cos\Omega \; x_{n-1} + \varepsilon_n \tag{6'}$$

expressions dans lesquelles ρ est le module d'un nombre complexe, voisin de l'unité, et $\varepsilon_n$ représente la quantité de bruit issue du bruit d'origine et filtrée à travers un filtre passe bande centré sur f:

$$\varepsilon_n = b_n + b_{n-2} - 2 \cos\Omega \; b_{n-1} \tag{7}$$

La relation de récurrence entre trois échantillons successifs, (6) ou (6)', représente une modélisation d'ordre 2 du système qui correspond à la détection d'une seule raie de modulation dans le signal d'entrée

5

du discriminateur. On notera que pour un signal d'entrée à plusieurs raies de modulation, il est aussi possible, au moyen d'une modélisation plus complexe du système, d'un ordre supérieur à 2, de réaliser la discrimination de ces raies multiples. Dans la description qui suit on s'en tiendra cependant à la discrimination d'une seule raie.

Pour estimer $\Omega$ on se propose d'utiliser une relation de prédiction linéaire du type:

$$x_n + a_1 x_{n-1} + a_2 x_{n-2} = \varepsilon_n \qquad (8)$$

la relation (8) pouvant être identifiée, terme à terme, à la relation (6) ou (6)'.

Le bruit $\varepsilon_n$ est considéré blanc, gaussien et donc décorrélé du signal utile recherché y(t). L'estimation repose sur l'accumulation des quantités $\varepsilon^2_n$ sur une certaine fenêtre d'analyse de N échantillons successifs, qui représentent chaque fois un point de la sinusoïde recherchée, et sur la minimisation de l'erreur quadratique moyenne ainsi obtenue, soit:

$$E = \sum_{n=0}^{N-1} \varepsilon^2_n$$

La minimisation de E s'exprime par:

$$\frac{\partial E}{\partial a_1} = 0, \text{ ce qui entraîne : } \sum_{n=0}^{N-1} \varepsilon_n . x_{n-1} = 0$$

$$\frac{\partial E}{\partial a_2} = 0, \text{ ce qui entraîne : } \sum_{n=0}^{N-1} \varepsilon_n x_{n-2} = 0$$

On obtient ainsi, en développant, deux équations à résoudre simultanément:

$$\sum_{n=0}^{N-1} x_n x_{n-1} + a_1 \sum_{n=0}^{N-1} x^2_{n-1} + a_2 \sum_{n=0}^{N-1} x_{n-1} x_{n-2} = 0$$

$$\sum_{n=0}^{N-1} x_n x_{n-2} + a_1 \sum_{n=0}^{N-1} x_{n-1} x_{n-2} + a_2 \sum_{n=0}^{N-1} x^2_{n-2} = 0 \qquad (11)$$

En posant :

$$R_{01} = \sum_{n=0}^{N-1} x_n x_{n-1}$$

$$R_{11} = \sum_{n=0}^{N-1} x^2_{n-1}$$

$$R_{12} = \sum_{n=0}^{N-1} x_{n-1} x_{n-2}$$

$$R_{02} = \sum_{n=0}^{N-1} x_n x_{n-2}$$

$$R_{22} = \sum_{n=0}^{N-1} x^2_{n-2}$$

le jeu d'équations précédentes (11) s'écrit plus simplement:

$$R_{01} + a_1 R_{11} + a_2 R_{12} = 0$$

$$R_{02} + a_1 R_{12} + a_2 R_{22} = 0$$

(12)

Dans le cas présent, la quantité $a_2$ doit valoir 1, respectivement $\rho^2$, si l'on identifie les relations (6) et (8), respectivement (6)' et (8), mais on préfère ignorer cette condition en première analyse et se servir de $a_2$ comme ce qu'on pourrait appeler un indicateur de convergence. Ceci revient à dire que si la valeur calculée de $a_2$ est trop différente de 1, on peut considérer qu'il y a une trop grande divergence et que la détermination correspondante de $y_n$ doit être rejetée comme étant erronée. Il vient finalement:

$$a_1 = \frac{R_{02} R_{12} - R_{01} R_{22}}{R_{11} R_{22} - R_{12}^2}$$

(13)

$$a_2 = \frac{R_{01} R_{12} - R_{02} R_{11}}{R_{11} R_{22} - R_{12}^2}$$

(14)

La détermination des quantités $a_1$ et $a_2$ est soumise à des conditions particulières d'utilisation et certaines caractéristiques sont favorables à une telle estimation:

En premier lieu les coefficients $R_{11}$ et $R_{12}$ sont représentatifs du coefficient d'autocorrélation $R_0$ qui traduit la puissance du signal reçu et qui peut être estimé sur un horizon plus large que la fenêtre d'analyse N proprement dite moyennant une normalisation. Par exemple, si l'on choisit N = 64, $R_0$ peut être estimé sur une fenêtre de 128 ou de 256 points. La fenêtre d'estimation de $R_0$ doit cependant rester assez étroite pour que, pendant le temps correspondant à cette fenêtre, on puisse considérer que le signal n'a pas subi de fluctuation de puissance. D'autre part, pour des raisons de simplicité de calcul essentiellement, on choisit de préférence une fréquence d'échantillonnage telle que: $f_e = 4f_o$. Ce choix conduit d'ailleurs à une précision optimale comme le démontrent les méthodes autorégressives dans la théorie de la prédiction linéaire. En troisième lieu, on s'intéresse aux applications pour lesquelles l'excursion de fréquence du signal modulant $\Delta F$ est petite devant la fréquence de la porteuse $f_o$, soit par exemple une valeur de $\Delta F$ de l'ordre de 500 Hz pour une valeur de $f_o$ de l'ordre de 10 000 Hz. Enfin, la bande passante du signal modulant est considérée comme étant faible par rapport à la fréquence de porteuse $f_o$.

Dans ces conditions, le traitement numérique à effectuer consiste à découper le signal d'observation, c'est-à-dire la porteuse modulée en tranches adjacentes contenant N échantillons chacune. Chaque tranche donne lieu à la détermination d'un point de la sinusoïde cherchée. Pour chaque tranche du signal, on fait l'approximation que la fréquence du signal d'observation reste constante, et on obtient:

$$a_2 = \frac{R_{01} R_{12} - R_{02} R_0}{R_0^2 - R_{12}^2}$$

(15)

Pour $f_e = 4f_o$ et pour $R_0$ normalisé à 1, on peut vérifier sur le cercle trigonométrique que:
$R_{01}$ tend vers 0
$R_{12}$ tend vers 0 et
$R_{02}$ tend vers −1.
On en déduit que: $a_2 \cong 1$, ce qui doit être vérifié par les mesures et les calculs.
De même, on obtient:

$$a_1 = \frac{R_{02} R_{12} - R_{01} R_0}{R_0^2 - R_{12}^2}$$

(16)

et $a_1$ tend vers 0, la valeur de $a_1$, bien que faible, n'étant cependant pas négligeable.
Si l'on se reporte aux formules (6) et (8) on peut écrire:

$$a_1 = - 2 \cos\Omega$$

(17)

Le fait que $\cos\Omega$ soit proche de 0 peut être exploité de manière intéressante en considérant que $\Omega$ tend vers $\Pi/2$ et donc:

7

$$\cos \Omega = \sin(\frac{\Pi}{2} - \Omega) \cong \frac{\Pi}{2} - \Omega \qquad (18)$$

des formules (16), (17) et (18) il résulte que:

$$\Omega - \frac{\Pi}{2} = \frac{1}{2} \frac{R_{02} R_{12} - R_{01} R_0}{R_0^2 - R_{12}^2} \qquad (19)$$

Or le rapprochement des formules (3) et (4) avec l'hypothèse que: $f_e = 4f_o$ conduit à écrire:

$$\Omega = \frac{\Pi}{2} + \frac{\Pi}{2} \frac{\Delta F}{f_o} y_n \qquad (20)$$

Si, dans cette dernière formule, on remplace $\Omega$ par sa valeur donnée par la formule (19) on obtient:

$$y_n = \frac{f_o}{\Pi \Delta F} a_1 \qquad (21)$$

$$y_n = \frac{f_o}{\Pi \Delta F} (\frac{R_{02} R_{12} - R_{01} R_0}{R_0^2 - R_{12}^2}) \qquad (22)$$

formules dans lesquelles $y_n$ est la valeur cherchée du signal modulant pour la tranche considérée. En partant des formules (6)' et (8), on aboutit par un calcul légèrement plus compliqué mais plus rigoureux à:

$$y_n = \frac{f_o}{\Pi \Delta F} \frac{a_1}{\rho}$$

soit :

$$y_n = \frac{f_o}{\Pi \Delta F} \frac{a_1}{\sqrt{a_2}}$$

soit encore:

$$y_n = \frac{f_o}{\Pi \Delta F} \frac{R_{02} R_{12} - R_{01} R_0}{\sqrt{(R_{01} R_{12} - R_{02} R_0)(R_0^2 - R_{12}^2)}} \qquad (22)'$$

Dans la pratique il est préférable d'utiliser la relation (22)' plutôt que la relation (22) et ceci d'autant plus que la valeur calculée de $a_2$ s'éloigne de la valeur 1. On calcule donc d'abord la valeur de $a_2$, par la formule (15) et seulement si cette valeur est suffisamment proche de 1, ce qui indique une convergence correcte, les valeurs de $a_1$ et de $y_n$ par les formules (16) et (22) ou (22)' respectivement sont ensuite calculées à leur tour.

Il est à noter que dans la mesure où l'excursion de fréquence $\Delta F$ n'est plus négligeable par rapport à la fréquence porteuse $f_o$, $\cos \Omega$ ne tend plus vers O et en conséquence il devient préférable de procéder à l'extraction de $\Omega$ en utilisant la fonction Arc cos.

Il est aussi possible de calculer la puissance de bruit en partant des formules (8) et (9); il vient:

$$\sum_{n=0}^{N-1} \varepsilon_n^2 = \sum_{n=0}^{N-1} (x_n + a_1 x_{n-1} + a_2 x_{n-2})^2$$

$$\sum_{n=0}^{N-1} \varepsilon_n^2 = (R_{00} + a_1 R_{01} + a_2 R_{02})$$
$$+ a_1(R_{01} + a_1 R_{11} + a_2 R_{12})$$
$$+ a_2(R_{02} + a_1 R_{12} + a_2 R_{22}) \tag{23}$$

$$\text{avec } R_{00} = \sum_{n=0}^{N-1} x_n^2$$

D'après le jeu d'équations 12, il vient:

$$\sigma^2 = \frac{1}{N} \sum_{n=0}^{N-1} \varepsilon_n^2 = \frac{1}{N} (R_0 + a_1 R_{01} + a_2 R_{02}) \tag{24}$$

$\sigma^2$ étant la puissance de bruit qui peut être estimée au moyen de la relation (24).

En ce qui concerne la réalisation, on notera qu'on peut appliquer la relation (22) sur une tranche d'observation de N points en calculant les quantités $R_{01}$, $R_{02}$ et $R_{12}$ par les relations:

$$R_{01} = \sum_{n}^{N_0 + N_{-1}} x_n x_{n-1}$$

$$R_{02} = \sum_{n=N_0}^{N + N_{-1}} x_n x_{n-2}$$

$$R_{12} = \sum_{n=N_0}^{N_0 + N_{-1}} x_{n-1} x_{n-2}$$

$R_0$ étant calculé sur un horizon qui peut être plus grande que N, soit L.

Une autre possibilité consiste à effectuer une estimation récursive point par point en utilisant:

$$R_{01}(N_0 + 1) = R_{01}(N_0) + x_{N0+N} x_{N0+N-1} - x_{N0} x_{N0-1}$$
$$R_{02}(N_0 + 1) = R_{02}(N_0) + x_{N0+N} x_{N0+N-2} - x_{N0} x_{N0-2}$$
$$R_{12}(N_0 + 1) = R_{12}(N_0) + x_{N0+N-1} x_{N0+N-2} - x_{N0-1} x_{N0-2}$$
$$R_0 (N_0 + 1) = R_0(N_0) + x_{N0+N}^2 - x_{N0+N-L}^2$$

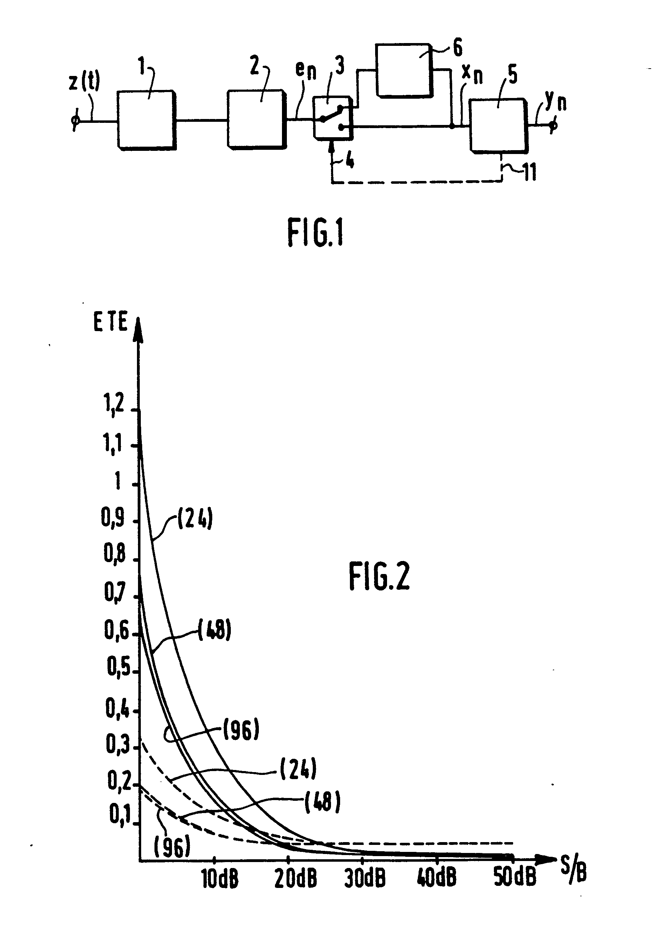

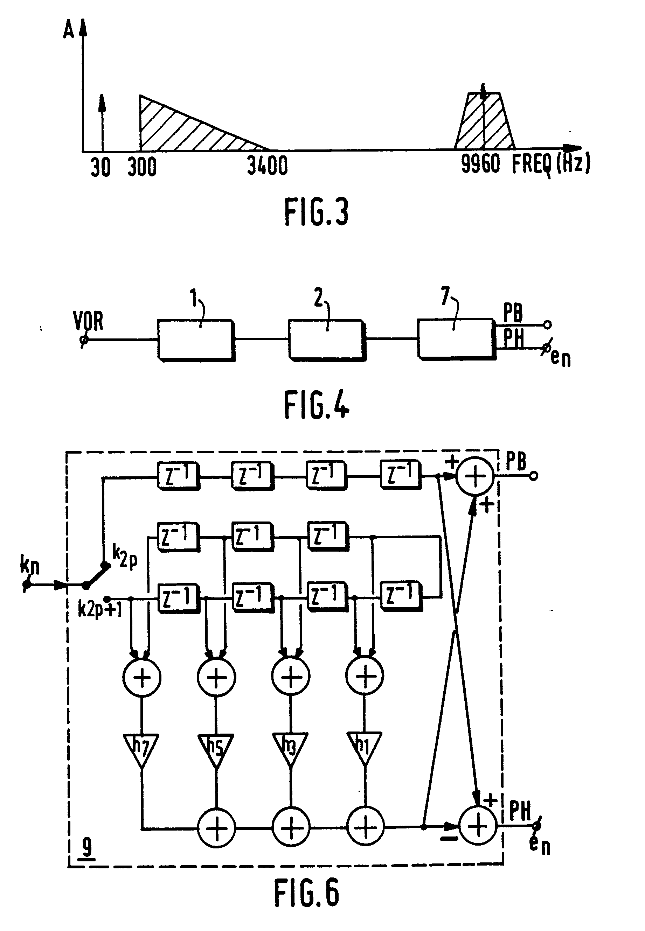

Le discriminateur selon l'invention est conçu, de préférence, pour fonctionner avec des conditions de rapport signal à bruit S/B largement variables, par exemple entre 0 et 50 dB. Lorsque le rapport S/B descend en dessous de 15 dB, on peut améliorer encore un peu le fonctionnement du système ainsi décrit en effectuant un préfiltrage autour de la bande uti le de discrimination, c'est-à-dire autour de la porteuse modulée avant discrimination autour de la fréquence $f_o$, dans l'hypothèse où: $f_o = f_e/4$. La figure 1 représente la chaîne de traitement du signal incorporant le discriminateur numérique selon l'invention. Le discriminateur proprement dit est de préférence réalisé au moyen d'un microprocesseur comme décrit ci-dessous pour l'application de l'invention à un signal composite VOR, tel que représenté à la figure 3. Le signal modulé en fréquence z(t) est fourni à un échantillonneur-bloqueur 1 d'un type connu qui

EP 0 224 315 B1

échantillonné à la fréquence $f_e$. Les échantillons sont ensuite fournis à un convertisseur analogique-numérique 2 dont la sortie est le siège d'échantillons numériques sous forme série $e_n$. Un commutateur à deux positions 3, commandable à partir d'un signal de commande, sur un conducteur 4, fonction de la valeur du rapport S/B, ce signal portant une valeur logique différente au-dessus et en dessous d'un seuil S/B = S', permet de transmettre les échantillons $e_n$ sous la forme $x_n$ en entrée du discriminateur numérique de fréquence 5 soit directement soit par l'intermédiaire d'un filtre 6 qui est un filtre passe-bande centré sur la fréquence $f_o$. Un exemple de filtrage élémentaire passe-bande centré sur $f_o = f_e/4$, est donné par l'expression suivante:

$$x_n = \frac{1}{8} (e_n - e_{n-2} + e_{n-4} - e_{n-6} + e_{n-8} - e_{n-10} + e_{n-12} - e_{n-14}), \quad (25)$$

Ce filtre, quoique rudimentaire, permet d'atténuer la puissance de bruit et ceci moyennant des opérations simples comme l'addition et la soustraction. La variance d'estimation du signal de modulation se trouve ainsi améliorée pour les faibles valeurs du rapport S/B. Le tableau 1 ci-dessous permet d'apprécier les résultats d'écart-type d'estimation pour un signal modulant d'amplitude a = 1 dans le cas de fenêtres d'observation (d'analyse) à 24, 48 et 96 points, pour différentes valeurs du rapport S/B exprimées de 10 en 10 en dB et pour chacune de ces valeurs avec (A) ou sans (S) préfiltrage.

| Rapport S/B | | Fenêtre d'observation | | |
|---|---|---|---|---|
| | | 24 | 48 | 96 |
| 50 dB | S | 0,011 | 0,004 | 0,006 |
| | A | 0,044 | 0,042 | 0,040 |
| 40 dB | S | 0,012 | 0,004 | 0,007 |
| | A | 0,044 | 0,042 | 0,040 |
| 30 dB | S | 0,023 | 0,010 | 0,011 |
| | A | 0,045 | 0,042 | 0,041 |
| 20 dB | S | 0,075 | 0,034 | 0,032 |
| | A | 0,055 | 0,043 | 0,043 |
| 10 dB | S | 0,32 | 0,18 | 0,16 |
| | A | 0,12 | 0,067 | 0,066 |
| 0 dB | S | 1,17 | 0,73 | 0,64 |
| | A | 0,32 | 0,19 | 0,18 |

La figure 2 est le graphe de l'écart-type d'estimation ETE indiqué dans le tableau, qui représente la variance d'estimation en fonction du rapport S/B, les courbes en trait plein indiquant la discrimination sans préfiltrage et les courbes en trait interrompu la discrimination avec préfiltrage; le nombre N de points de la fenêtre d'observation est indiqué entre parenthèses. Cette figure montre l'intérêt du filtre passe-bande entre 15 dB et 0 dB où l'écart type est singulièrement amélioré. Dans cette dernière fourchette de rapport S/B, on peut évaluer à 10 dB le gain obtenu sur le rapport S/B avec un tel filtre. Par ailleurs la figure 2 fait apparaître que le nombre N ne doit pas plus être trop petit, au risque d'avoir un écart-type d'estimation trop grand pour les valeurs du rapport S/B les plus faibles. Etant données les valeurs choisies pour différentes fréquences indiquées ci-dessus on constate que la valeur N = 24 serait trop faible, alors que les valeurs N = 48 ou N = 96 conviennent. On peut aussi choisir la valeur N = 64 qui, du fait qu'il s'agit d'une puissance de deux, présente l'avantage de simplifier les calculs.

On se propose d'appliquer le principe décrit ci-dessus à la recherche de la phase de référence dans le signal VOR reçu par un équipement de bord VOR-ILS. Le spectre du signal composite reçu A(FREQ.) est représenté à a figure 3. Il contient une composante à 30 Hz donnant la phase variable, une bande audio de 300 à 3400 Hz (ou un signal d'identification à 1020 Hz), et une porteuse à 9960 Hz modulée en fréquence avec une excursion de 480 Hz par le signal 30 Hz donnant la phase de référence. C'est ce signal 30 Hz modulant en fréquence que l'on cherche à reconstituer.

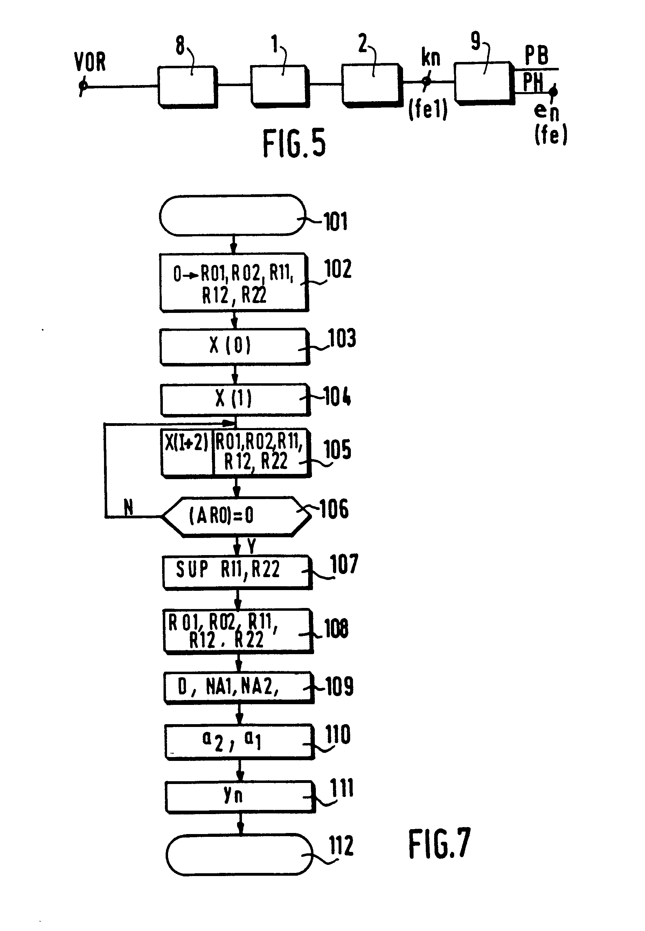

Une première solution pour l'application du principe décrit ci-dessus consiste à échantillonner le signal VOR à une fréquence de: $4 \times 9960 = 39840$ Hz, puis à séparer les parties basses du spectre (composante à 30 Hz et signal audio) et les parties hautes (signal modulé en fréquence) et enfin à appliquer la procédure de discrimination sur la porteuse à 9960 Hz. Cette dernière fréquence est bien égale à $f_e/4$ et la procédure de calculs indiquée ci-dessus s'applique correctement. La chaîne de traitement qui conduit du signal analogique VOR au signal numérique $e_n$ est représentée à la figure 4. Elle est constituée par la succession d'un échantillonneur bloqueur 1, d'un convertisseur analogique-numérique 2 et d'un filtre numérique séparateur 7, d'un type connu, dont la sortie passe haut, référencée PH, est le siège du signal $e_n$, au même rythme que le signal d'entrée du séparateur de bandes 7. Pour la fréquence $f_e$ de 39840 Hz choisie, la charge de calcul est importante; il est avantageux de baisser la fréquence d'échantillonnage.

En conséquence une deuxième solution consiste à choisir au départ une fréquence d'échantillonnage $f_{e1}$ telle que:

$$f_{e1} = \frac{8}{3} \times 9960 = 26560 \text{ Hz}$$

Avant l'opération d'échantillonnage, le signal doit, dans ce cas, traverser un filtre antirepliement analogique de manière à limiter la fréquence maximale du spectre à une valeur inférieure à 13280 Hz (fréquence de coupure: $f_c = f_{e1}/2$). Comme la partie haute du signal VOR est modulée en fréquence avec une excursion de fréquence nominale de 480 Hz et s'étend de ce fait jusqu'à 10600 Hz, ce filtre antirepliement doit posséder une bande passante de 0 à 10600 Hz. La bande de transition vaut: $2(f_{e1}/2 - 10600) = 5360$ Hz et la bande affaiblie s'étend donc de $10600 + 5360 = 15960$ Hz à l'infini. L'ordre du filtre est déterminé par le rapport entre la bande de transition et la fréquence de coupure, soit: 5360/13280, d'où un ordre inférieur ou égal à trois. L'opération qui suit l'échantillonnage consiste à séparer les parties basses et hautes du spectre. Pour cela, on utilise un filtre numérique séparateur de bandes qui est de préférence un filtre demi bande à 4 coefficients distincts tel que représenté à la figure 6. La chaîne de traitement de signal en amont du discriminateur numérique est alors celle de la figure 5, constituée d'un filtre passe bas antirepliement analogique 8, d'un échantillonneur-bloqueur 1, d'un convertisseur analogique-numérique 2 et d'un filtre numérique séparateur de bandes 9 représenté plus en détail à la figure 6. Le filtre 9 est un filtre transverse demi-bande à réponse impulsionnelle finie, d'un type connu, il opère en alternance sur des échantillons $k_n$ pairs (n = 2p) et impairs (n = 2p + 1), ce qui est représenté, sur la figure 6 par un commutateur. Cette structure lui permet de réaliser un sous-échantillonnage par deux. Il reçoit des échantillons $k_n$ à la cadence de 26560 Hz et fournit à sa sortie passe haut PH des échantillons $e_n$ à la cadence de 13280 Hz. La structure de filtre de la figure 6 est conçue pour réaliser l'équation suivante:

$$e_n = k_{n-8} - h_1(k_{n-7} + k_{n-9})$$
$$- h_3(k_{n-5} + k_{n-11})$$
$$- h_5(k_{n-3} + k_{n-13})$$
$$- h_7(k_{n-1} + k_{n-15})$$

Les retards $Z^{-1}$ indiqués à la figure 6 sont au rythme de la sortie, soit $f_{e1}/2$.

La réponse est donc symétrique de part et d'autre d'un coefficient principal égal à 1 avec seulement des coefficients impairs, les coefficients pairs étant nuls. Du fait du sous-échantillonnage par deux, la sortie PH est translatée de 13280 Hz, soit $f_{e1}/2$, et la nouvelle porteuse avant discrimination est à la fréquence de 3320 Hz ($13280 - 9960 = 3320$ Hz); en effet, le sous-échantillonnage par deux donne, pour le spectre du signal VOR représenté à la figure 3, une image symétrique par rapport à $f_{e1}/2$ et, après décalage vers la gauche de 13280 Hz, la partie du spectre à traiter, c'est-à-dire la porteuse modulée en fréquence se trouve centrée autour de la fréquence 3320 Hz. On constate alors que la nouvelle fréquence d'échantillonnage à considérer pour le discriminateur 5 est: $f_e = f_{e1}/2 = 13280$ Hz, soit quatre fois 3320 Hz. Autrement dit, la sortie passe haut se trouve dans les conditions requises pour être traitée par la procédure de discrimination précédemment décrite. Plus généralement, avec la chaîne de traitement de la figure 5, la fréquence d'échantillonnage réduite se déduit de la relation:

$$f_e = \frac{f_o}{3} + f_o, \text{ soit :}$$

$$f_e = \frac{4}{3} f_o$$

La fréquence d'échantillonnage est donc réduite au tiers de sa valeur par rapport à la première solution, tout se passant comme si la fréquence de la porteuse était elle-même divisée par trois. Dans ce cas particulier, on peut utiliser indifféremment, pour le calcul de $\Omega$ et par suite de $y_n$, soit le développement limité de la relation (18) soit la fonction Arc cos qui complique un peu les calculs mais apporte une plus grande précision.

Les échantillons $e_n$ et par suite $x_n$ (voir figure 1) sont ensuite traités par un microprocesseur, de préférence un TMS 32010 de la société Texas Instruments, pour réaliser les calculs indiqués ci-dessus. Le discriminateur selon l'invention est donc constitué entièrement par un microprocesseur, muni de préférence de mémoires auxiliaires, ce microprocesseur pouvant incorporer aussi dans le cas de l'application VOR à fréquence d'échantillonnage réduite le filtre numérique séparateur de bandes 7 et aussi, éventuellement, le filtre numérique 6.

La fonction essentielle du discriminateur numérique 5 (voir figure 1) est de déterminer la valeur $y_n$ par la relation (22) ci-dessus, à partir du nombre prédéterminé N d'échantillons $x_n$ consécutifs prélevés entre les dates $t_q$ et $t_{q+1}$, après quoi on passe à la valeur suivante de $y_n$ déterminée à partir des N échantillons $x_n$ suivants (entre les dates $t_{q+1}$ et $t_{q+2}$). Pour éviter une confusion de notations, on rappelle qu'en toute rigueur, à chaque échantillon $x_n$ correspond un échantillon $y_n$ distinct mais que par approximation on considère, tranche par tranche, que les valeurs de N échantillons de sortie $y_n$ consécutifs sont égales, cette valeur commune étant précisément notée $y_n$ par commodité d'écriture. N échantillons de sortie peuvent alors être remplacés chaque fois par leur représentant $y_n$ ce qui correspond à un échantillonnage en sortie réduit dans le rapport N par rapport à l'entrée soit une fréquence en sortie de $f_e/N$. Dans l'exemple décrit ci-dessous la valeur de N est fixée à 64. De préférence, les échantillons $x_n$ sont emmagasinés, par paquets de 64, dans une RAM externe, désignée ci-après comme le port d'entrée-sortie PA1 qui constitue des moyens d'accumulation de ces échantillons d'entrée. Des éléments tampon et des moyens de séquencement connus, non représentés, permettent le remplacement de 64 échantillons d'entrée par les 64 échantillons suivants au cours d'une séquence de programme de calcul de $y_n$ postérieure à la lecture des échantillons, le processeur travaillant en temps réel.

La figure 7 montre l'ordinogramme général du fonctionnement du discriminateur selon l'invention; cet ordinogramme, ainsi que les suivants, est constitué de différentes cases. A la figure 7, la case 101 indique le début du programme. A la case 102, on fait les initialisations nécessaires consistant, pour les échantillons $x_n$, à se placer en lecture au début de la zone de mémoire qui les contient et, pour les coefficients $R_{01}$, $R_{02}$, $R_{11}$, $R_{12}$, $R_{22}$, à charger leurs cases mémoires respectives référencées R01, R02, R11, R12, R22, avec la valeur 0. Les deux premiers échantillons $x_0$ et $x_1$ sont lus (cases 103 et 104) puis, au moyen d'un calcul en boucle (cases 105 et 106), l'échantillon suivant est lu et les coefficients $R_{01}$ à $R_{22}$ sont calculés. Pour cela, le registre auxiliaire AR0 qui a été préalablement chargé à la valeur 63 sert de compteur, étant décrémenté d'une unité à chaque tour dans la boucle, jusqu'à atteindre la valeur 0 qui marque la fin du calcul des coefficients et commande la sortie de la boucle. A la case 107 on détermine lequel est le plus grand parmi les deux coefficients $R_{11}$ et $R_{22}$, après quoi (case 108) les autres coefficients sont mis au format de la valeur trouvée à la case précédente. Les quantités $R_{11} R_{22} - R_{12}^2$, $R_{02} R_{12} - R_{01} R_{22}$, $R_{01} R_{12} - R_{02} R_{11}$ qui constituent respectivement le dénominateur commun des coefficients $a_1$ et $a_2$, le numérateur de $a_1$ et le numérateur de $a_2$ sont calculées à la case 109. Les valeurs de $a_2$ et $a_1$ sont ensuite calculées, à la case 110 et comparées à des valeurs de seuil prédéterminées, ce qui permet de déclarer valides ou non les valeurs de $a_1$ et $a_2$ selon que des critères de convergence déjà évoqués ci-dessus et matérialisés par ces seuils peuvent être considérés comme satisfaits ou non. On peut ensuite passer au calcul de l'échantillon courant de sortie $y_n$ (case 111). La case 112 indique la fin de l'ordinogramme général.

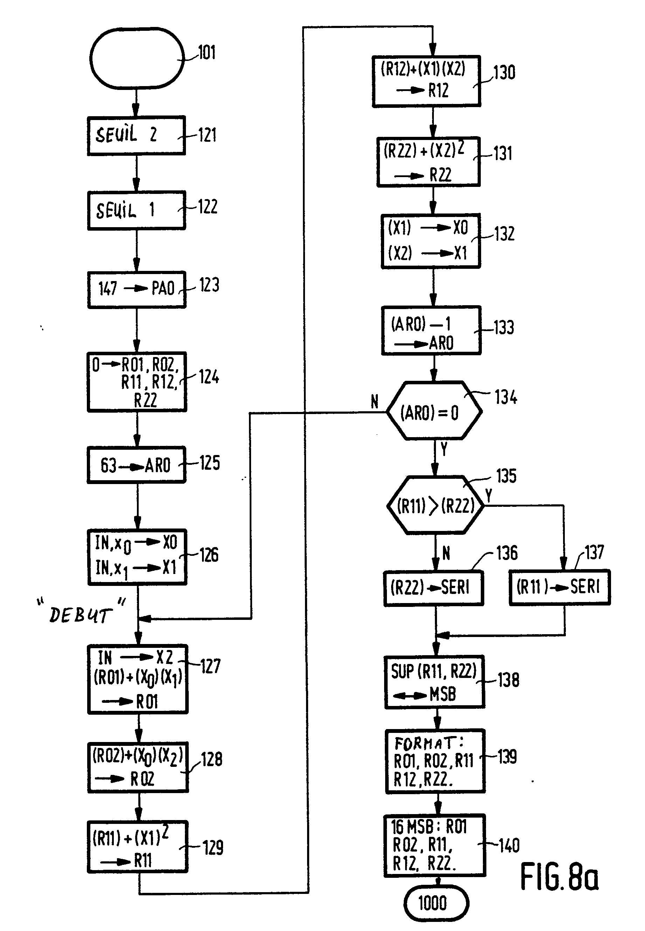

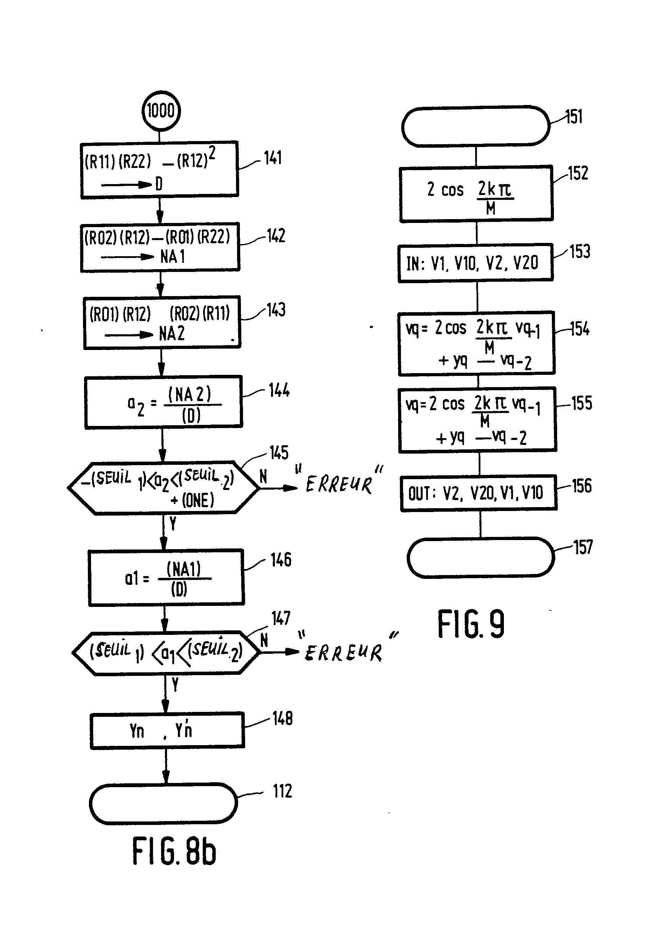

L'ordinogramme des figures 8a et 8b indique, entre les cases 101 et 112, le déroulement plus détaillé de l'ordinogramme de la figure 7. Des opérations mathématiques effectuées en base deux sur les coefficients $R_{11}$ et $R_{22}$, comme décrit ci-dessous, permettent de rapprocher ces derniers de l'unité, sans toutefois les normaliser à 1, pour ne pas compliquer inutilement les calculs; en conséquence on peut s'attendre à ce que les valeurs déterminées par la suite pour les coefficients $a_1$ et $a_2$ ne soient pas très proches de 0 et de 1 respectivement. Dans la pratique, on se fixe deux valeurs de seuil positives $s_1$ et $s_2$ toutes deux voisines de 1, $s_1$ par défaut et $s_2$ par excès et on pose que, pour que la détermination de

EP 0 224 315 B1

l'échantillon courant de sortie du discriminateur $y_n$ soit acceptable et déclarée valide, les valeurs des coefficients $a_1$ et $a_2$ correspondants doivent satisfaire aux inégalités suivantes:

$$s_1 < a_2 < s_2 \qquad (26)$$

$$et - s_1 < a_1 < s_1 \qquad (27)$$

Dans l'exemple décrit ci-dessous, on choisit les valeurs: $s_1 = 0{,}8$ et $s_2 = 1{,}2$. Ces deux valeurs de seuil sont en fait déterminées par l'expérience et peuvent être modifiées à volonté dans leurs emplacements mémoire respectifs à 16 bits SEUIL 1 et SEUIL 2 lors d'un étalonnage de l'appareil en fonctionnement. Les valeurs décimales 1,2 et 0,8 sont élaborées à partir des deux valeurs respectives 1, contenue dans un emplacement mémoire ONE et 3, soit 11 en binaire, contenue dans une mémoire TROIS. En premier lieu, on détermine la valeur 0,2 en ajoutant dans la partie droite (fractionnaire) de l'accumulateur les valeurs binaires 11 décalées successivement vers la gauche de 4, 8 et 12 bits, ce qui donne la valeur binaire: 0,0011001100110011, valeur très proche de 0,2 en décimal, qui est emmagasinée dans la mémoire SEUIL 2 (case 121 sur la figure 8a). La valeur $s_2 = 1{,}2$ est en fait obtenue par la suite par concaténation des contenus respectifs des mémoires ONE et SEUIL 2 ((ONE) + (SEUIL 2)). De façon analogue, la valeur 0,8 est obtenue (case 122) en ajoutant les valeurs binaires 11 décalées successivement de 2, 6, 10 et 14 bits et le résultat 0,1100110011001111 est mis dans la mémoire SEUIL 1. Comme indiqué ci-dessus, les 64 échantillons $x_n$ sont rangés par ordre d'arrivée en RAM externe, aux emplacements mémoire 147 à 210 du port PA1, qui constitue des moyens d'accumulation, le plus ancien échantillon étant en 147. Au moyen d'un autre port PA0 utilisé comme un compteur incrémenté d'une unité à chaque instruction IN du programme, les échantillons $x_n$ sont ainsi lus successivement et placés provisoirement dans une mémoire de transit X2 de la RAM interne au microprocesseur. Pour plus de détails sur cette possibilité particulière d'extension mémoire, on peut se reporter au manuel d'utilisation TMS 32010 User's guide 1983 de la société Texas Instruments, pages 6—2 et 6—3, incorporé ici par référence. A la case 123, on charge une mémoire programme SERI avec la valeur 147 et cette valeur est ensuite transférée, en tant que valeur de départ pour l'incrémentation dans le port PA0. Les mémoires affectées aux coefficients $R_{01}$ à $R_{22}$, soit R01L, R01H, R02L, R02H, R11L, R11H, R12L, R12H, R22L, R22H, qui constituent des premiers moyens de stockage, la lettre L désignant chaque fois les 16 bits de la partie basse et la lettre H les 16 bits de la partie haute de chaque coefficient, sont initialisées, c'est-à-dire chargées avec la valeur 0 (case 124). Le registre AR0 utilisé comme compteur de boucle pour le calcul des coefficients $R_{01}$ à $R_{22}$ est ensuite chargé avec la valeur 63 (case 125), puis les deux premiers échantillons $x_0$ et $x_1$ sont transférés du port PA1 dans les mémoires respectives X0 et X1 (case 126). A l'étiquette "DEBUT", l'échantillon suivant, soit $x_2$, est transféré dans la mémoire X2 et on peut alors procéder au calcul du premier terme de chaque coefficient $R_{01}$ à $R_{22}$ conformément aux relations suivantes:

$$(R_{01}) + (X0) \times (X_1) \longrightarrow R01 \qquad (31) \qquad (case\ 127)$$

$$(R_{02}) + (X0) \times (X_2) \longrightarrow R02 \qquad (32) \qquad (case\ 128)$$

$$(R_{11}) + (X1)^2 \longrightarrow R11 \qquad (33) \qquad (case\ 129)$$

$$(R_{12}) + (X1) \times (X2) \longrightarrow R12 \qquad (34) \qquad (case\ 130)$$

$$(R_{22}) + (X_2)^2 \longrightarrow R22 \qquad (35) \qquad (case\ 131)$$

à la case 132 on opère les transferts entre mémoires suivants: $(X1) \rightarrow X0$ et $(X_2) \rightarrow X1$. En 133, le registre auxiliaire AR0 est décrémenté d'une unité et le nouveau contenu de AR0 (62) est testé à la case 134. Comme ce contenu est positif on revient à l'étiquette "DEBUT", la mémoire X2 est chargée avec l'échantillon suivant, soit $x_3$ et le deuxième terme des coefficients $R_{01}$ à $R_{22}$ est calculé et ajouté aux précédents (cases 127 à 131), conformément aux relations 31 à 35. La boucle de calcul est effectuée autant de fois que nécessaire, les mémoires R01L, R01H à R22L, R22H contiennent la valeur des coefficients respectifs $R_{01}$ à $R_{22}$, le registre AR0 atteint alors la valeur 0, le test AR0 = 0 de la case 134 se révèle positif et on sort de la boucle. Pour le calcul des coefficients $R_{01}$ à $R_{22}$ on notera que les échantillons $x_0$ à $x_{63}$ sont, dans leurs mémoires respectives, inscrits sur 12 bits. En conséquence, chaque terme du type $x_u\,x_v$ occupe un format de 24 bits et la somme de 64 de ces termes un format de 30 bits, ce qui justifie l'utilisation de deux emplacements mémoire (L et H) pour l'inscription de chacun des coefficients $R_{01}$ à $R_{22}$. A la case 135 on teste lequel des deux coefficients $R_{11}$ ou $R_{22}$ est le plus grand et, selon qu'il s'agit de $R_{22}$ (case 136) ou de $R_{11}$ (case 137) on charge la mémoire programme SERI avec la partie haute de cette valeur la plus grande désignée par SUP (R11, R22), c'est-à-dire avec (R11H) ou avec (R22H). La suite du calcul consiste à charger la partie haute de l'accumulateur avec (SERI) et à décaler successivement cette valeur de un bit vers la gauche jusqu'à ce qu'un 1 apparaisse dans le MSB de l'accumulateur. Si au bout de 15 décalages successifs

13

EP 0 224 315 B1

le MSB est toujours égal à 0 ceci signifie que l'on a (SERI) = 0. On considère alors que la détermination de $y_n$ est mauvaise parce qu'elle serait obtenue à partir de valeurs d'échantillons $x_0$ à $x_{63}$ trop faibles, on ne poursuit pas le calcul de $y_n$ et on va directement à l'étiquette "ERREUR" (ce qui n'est pas représenté sur la figure 8a). Dans le cas le plus probable, la valeur 1 dans le MSB est obtenue au bout d'un nombre entier r de décalages (r < 15) et on sort de la boucle de calcul qui opère les décalages successifs à raison de un par cycle. Pour effectuer cette boucle de calcul (non représentée) on peut par exemple utiliser en décrémentation le registre auxiliaire AR1 que l'on charge initialement avec la valeur 15 et le registre auxiliaire AR0 destiné à enregistrer la valeur r après être sorti de la boucle. On passe ensuite, à la case 139, à une autre boucle de calcul qui sert à décaler de r bits vers la gauche toutes les valeurs de coefficients $R_{01}$ à $R_{22}$. Pour cela, on utilise en décrémentation le registre auxiliaire AR0 chargé initialement avec la valeur r. A ce stade de calcul, les contenus des mémoires R01H, R02H, R11H, R12H, R22H qui sont censés représenter les valeurs entières des coefficients associés, sont sur un format de 16 bits, le plus grand d'entre eux utilisant les 16 bits. On peut alors envisager de négliger complètement les parties fractionnaires des coefficients $R_{01}$ à $R_{22}$ contenues dans les mémoires respectives R01L à R22L mais, de préférence, on pratique un arrondi supplémentaire qui consiste à pondérer de 1 en positif respectivement en négatif selon le signe positif respectivement négatif du coefficient correspondant le bit de plus fort poids de la partie basse de ce coefficient, après quoi seule la nouvelle partie haute du coefficient (après augmentation respectivement diminution éventuelle d'une unité) est conservée pour la suite des calculs afin de simplifier ces derniers (case 140). Le calcul se poursuit (figure 8b) par la détermination des coefficients $a_1$ et $a_2$. On calcule d'abord le dénominateur commun à $a_1$ et $a_2$ selon la relation:

$$(R11H) \times (R22H) - (R12H^2 \rightarrow D \qquad (36) \text{ (case 141—figure 8b)}$$

De façon analogue on calcule ensuite les numérateurs respectifs des coefficients $a_1$ et $a_2$ qu'on emmagasine dans les mémoires respectives NA1 et NA2, selon les relations:

$$(R02H) \times (R12H) - (R01H) \times (R22H) \rightarrow NA1H, NA1L \qquad (37) \text{ (case 142)}$$
$$(R01H) \times (R12H) - (R02H) \times (R11H) \rightarrow NA2H, NA2L \qquad (38) \text{ (case 143)}$$

Pour les trois opérations décrites ci-dessus, on notera que les produits partiels du type $(R11H) \times (R22H)$ occupent, dans le registre P et l'accumulateur du microprocesseur, un format de 32 bits, ainsi que les différences entre produits partiels. Pour simplifier les calculs ultérieurs, seul le contenu des 16 bits de la partie haute de l'accumulateur (partie entière) est stocké dans la mémoire après un arrondi éventuel, pour le dénominateur commun, alors que les valeurs respectives des numérateurs de $a_1$ et $a_2$ sont stockées chacune dans deux emplacements mémoires (partie entière et partie fractionnaire). La valeur du coefficient $a_2$ est calculée par division:

$$a_2 = \frac{(NA2)}{(D)} \qquad (39) \qquad (\text{case } 144)$$

Le résultat de la division qui manipule des dividendes à 32 bits est emmagasiné dans deux mémoires associées au sous-programme de division DIV32, QUOTIM (partie entière) et QUOTIL (partie fractionnaire). Après quoi on vérifie tout d'abord que le résultat est positif par test de (QUOTIM) > 0, ce qui est implicite en vertu de l'inégalité (26) ci-dessus. Si tel n'est par le cas on va à l'étiquette "ERREUR". Pour (QUOTIM) > 0, le test de convergence de l'inégalité (26) est effectué (case 145) c'est-à-dire qu'on fait successivement les opérations suivantes:

$$(QUOTIM) + (QUOTIL) - (SEUIL1)$$

Si le résultat de cette opération est négatif, on va à l'étiquette "ERREUR", sinon on poursuit le test par:

$$(QUOTIM) + (QUOTIL) - (SEUIL2) - (ONE) \times 2^{16}$$

Si le résultat de cette opération est positif, on va à l'étiquette "ERREUR", sinon on passe au calcul de $a_1$:

$$a_1 = \frac{(NA1)}{(D)} \qquad (41) \qquad (\text{case } 146)$$

Le résultat de la division est emmagasiné comme précédemment dans les mémoires QUOTIM et QUOTIL (à la place de $a_2$) qui constituent des deuxièmes moyens de stockage. Pour que la valeur de $a_1$ sont

acceptable, c'est-à-dire suffisamment proche de 0 par valeurs positives ou négatives, on vérifie qu'elle satisfait au test de l'inégalité (27) (case 147), c'est-à-dire qu'on teste tout d'abord le signe de $a_1$:

si (QUOTIM) + (QUOTIL) > 0 on fait l'opération:
(QUOTIM) + (QUOTIL) − (SEUIL1)
si ce résultat est positif on va à "ERREUR", sinon ((QUOTIM) + (QUOTIL) < 0), on fait l'opération:
(QUOTIM) + (QUOTIL) + (SEUIL1)

si ce résultat est négatif, on va à "ERREUR", sinon on déclare valide le calcul de $a_1$ et on peut alors passer au calul de $y_n$.

Dans le présent exemple de réalisation on préfère calculer la valeur de $y_n$ par application de la formule (22)' ci-dessus, soit, en utilisant les notations choisies pour la description de l'ordinogramme de la figure 8:

$$y_n = K_1 \frac{(NA_1)}{\sqrt{(NA2) \; x \; (D)}} \qquad (42)$$

$$\text{avec } K_1 = \frac{f_0}{\Pi \Delta F}$$

$K_1$ est une constante multiplicative que l'on peut en général omettre. En effet, le but ultime de la discrimination effectuée sur le signal composite VOR qui constitue l'application préférée de l'invention consiste à déterminer en temps réel la phase dite de référence de ce signal. Ce but est atteint en isolant une raie de fréquence 30 Hz, cette sinuosoïde unique étant obtenue sous forme de points d'ordonnée $y_n$ fournis à intervalles réguliers. A partir des valeurs $y_n$ il est ensuite possible, par une méthode numérique dont un exemple est donné ci-dessous, d'extraire l'amplitude et la phase de la raie recherchée. Or le coefficient $K_1$ n'influence que la valeur de l'amplitude alors que c'est essentiellement la phase qui est recherchée. Par ailleurs, on notera que la valeur correcte de l'amplitude peut être obtenue à la fin des calculs en faisant intervenir seulement à ce stade le coefficient multiplicatif $K_1$. La valeur $y'_n$ représentative de $y_n$ effectivement calculée est donc:

$$y'_n = \frac{(NA1)}{\sqrt{(NA2) \; x \; (D)}} \qquad (44)$$

Pour cela, on réalise d'abord l'opération:

$$(NA2) \times (D) \rightarrow P$$

étant donné le format de (NA2) qui est en fait de 32 bits, dans les mémoires NA2H et NA2L, on pratique d'abord de préférence un arrondi, en ajoutant 1 juste après la virgule, après quoi seuls les 16 MSB sont stockés dans la mémoire NA2H et c'est cette dernière valeur qui est utilisée pour la multiplication indiquée ci-dessus. Le résultat est fourni sur 32 bits au registre P. Il est ensuite fait appel à un sous-programme RACAR qui effectue l'opération:

$$\sqrt{(NA2) \; x \; (D)} \rightarrow X$$

X étant un emplacement mémoire qui contient donc 16 bits.

Après quoi, NA1 est transféré des emplacements mémoire DLOWM et DLOWL à l'accumulateur et l'opération finale indiquée par la relation (44) est effectuée par appel du sous-programme DIV32. La valeur de $y'_n$ ainsi obtenue est emmagasinée sous forme d'une partie entière à 16 bits et d'une partie fractionnaire à 16 bits dans les mémoires respectives QUOTIM et QUOTIL qui constituent les deuxièmes moyens de stockage.

La méthode numérique utilisée pour extraire la phase du signal à 30 Hz est, de préférence, la méthode dénommée "transformée de Fourier discrète récursive", ou "TFD récursive" qui est indiquée dans ses grandes lignes en annexe. Le problème posé se ramène au calcul de:

$$Y(k) = \sum_{q=0}^{M-1} y_q \; e^{-j \; 2\Pi \; \frac{q \cdot k}{M}} \qquad (45)$$

$$Y(k) = a \; e^{j\varphi} \qquad (46)$$

Y(k) étant un nombre complexe qui représente en amplitude (a) et en phase ($\varphi$) la raie spectrale à 30 Hz à laquelle on s'intéresse.

Dans la relation (45):

M est le nombre entier de valeurs $y_n$ successives distinctes choisi pour le calcul, représentant plusieurs sinusoïdes du signal 30 Hz modulant, par exemple, M = 83 (12 sinusoïdes pour une fréquence $f_e/N$ de 207,5 Hz des échantillons de sortie $y_n$):

$$k \text{ est tel que : } \frac{k}{M} = \frac{F \times N}{f_e}$$

soit, avec les valeurs précédemment choisies:

$$k = \frac{83 \times 30 \times 64}{13280}$$

$$k = 12$$

On souhaite déterminer Arg Y(k) et |Y(k)|.

Pour ce faire on peut utiliser l'algorithme rapide donné en annexe, défini par:

$$v_{-1} = 0$$

$$v_{-2} = 0$$

$$\text{pour} \quad q = 0 \text{ à } M - 1$$

$$v_q = y_q + 2 \cos \frac{2k\Pi}{M} \cdot v_{q-1} - v_{q-2} \tag{47}$$

après que M valeurs (réelles) de $v_q$ ont été calculées:

$$Y(k) = e^{+j2\Pi \frac{k}{M}} v_{M-1} - v_{M-2} \tag{48}$$

Pour chaque échantillon $y_n$ (c'est-à-dire $y_q$ lorsqu'on comptabilise par rapport à M) en sortie du discriminateur 5, on procède donc au calcul du $v_q$ correspondant, selon la relation (47), dans la tranche 0 à M-1 considérée:

En pratique, pour pouvoir doubler le taux de rafraîchissement des mémoires, on préfère entrelacer à 50% les déterminations de Y(k), c'est-à-dire que pour chaque valeur de $y_q$ deux valeurs de $v_q$ sont calculées, une première valeur $v_q$ résultant d'un couple de valeurs antérieures $v_{q-1}$, $v_{q-2}$, précédemment calculées contenues respectivement dans les mémoires V1, V2 et une deuxième valeur $v_q$ résultant d'un autre couple de valeurs antérieures $v_{q-1}$, $v_{q-2}$ précédentes différentes contenues dans des mémoires respectives V10, V20. L'entrelacement est tel que, lorsque le rang est maximum pour un couple de valeurs $v_{q-1}$, $v_{q-2}$, soit M—1 et M—2 (82 et 81) et propre à ce que la valeur de Y(k) associée puisse être calculée selon la formule (48), le rang de l'autre couple de valeurs $v_{q-1}$, $v_{q-2}$ est égal à

$$\frac{M - 1}{2} \text{ et } \frac{M - 3}{2} \tag{41 et 40}$$

pour l'autre couple de valeurs $v_{q-1}$, $v_{q-2}$.

Les ports PA1 et PA0, travaillant respectivement en tant que RAM externe et compteur à positionnement de comptage initial et incrémentation associé, peuvent être à nouveau utilisés pour la mise en mémoire des valeurs $v_{q-1}$, $v_{q-2}$, et $v_q$ nécessaires aux calculs.

L'ordinogramme de la figure 9 illustre le calcul des deux valeurs $v_q$ associées à chaque valeur $y_q$. La case 151 indique le début du programme qui, de préférence, fait suite au programme de calcul de $y_n$ (figures 8a et 8b). A la case 152 on lit la valeur de:

$$2\cos \frac{2k\Pi}{M}$$

Cette valeur, qui est par exemple emmagasinée à l'emplacement mémoire 290 de PA1 est transférée, par l'intermédiaire de PA0 à l'emplacement RXN9H de la mémoire de données interne du microprocesseur TMS 32010. A la case 153 on transfère, de façon analogue, par une série d'instructions IN, les contenus des emplacements mémoire 608, 609, 610, 611 dans les mémoires respectives V1, V10, V2, V20 du microprocesseur. La case 154 symbolise les opérations suivantes pour la séquence dite récente de calcul de TFD qui concerne (V1) et (V2):

$$(V1) \times (RXN9H) \longrightarrow ACC$$
$$(ACC) + (QUOTIM) \longrightarrow ACC$$
$$(ACC) - (V2) \longrightarrow ACC$$
$$(ACC) \longrightarrow V2$$

ce qui réalise l'opération littérale:

$$v_q = a_{1q} + 2 \cos 2k \frac{\Pi}{M} \cdot v_{q-1} - v_{q-2}$$

ou l'opération :

$$v_q = \frac{a_{1q}}{\sqrt{a_{2q}}} + 2 \cos 2 \frac{k\Pi}{M} \cdot v_{q-1} - v_{q-2}$$

Le nouveau contenu de V2 passe ainsi de la valeur $v_{q-2}$ à la valeur $v_q$, (V1) restant à ce stade inchangé.

La case 155 symbolise les mêmes opérations qu'à la case 154 mais pour la séquence dite à plus de 50% de calcul de TFD qui concerne V10 et V20. Le nouveau contenu de V20 passe ainsi de la valeur $v_{q-2}$ à la valeur. $v_q$, (V10) restant à ce stade inchangé.

A la case 156, on charge PA0 à la valeur 608 puis on transfère, par une série d'instructions OUT, les contenus des emplacements mémoires respectifs V2, V20, V1 et V10, dans cet ordre, dans les emplacements mémoires respectifs 608, 609, 610, 611 du port PA1.

Par cette dernière opération de rangement on réalise les substitutions nécessaires pour passer des valeurs $v_q$, $v_{q-1}$ aux valeurs $v_{q-1}$, $v_{q-2}$, pour chaque couple de valeurs adjacentes v, ce qui est nécessaire en vue du calcul suivant (figures 8a, 8b et 9) qui est précisément caractérisé par une augmentation de 1 des indices muets n (figures 8a, 8b) et q (figure 9). La case 157 marque la fin du calcul et le retour à la case 123 (figure 8a) pour le calcul des valeurs suivantes de $y_n$ ($y_q$), $v_q$ et $v_{q-1}$. Un comptage, qui n'est pas explicité ici permet de savoir quels sont les couples $v_{q-1}$, $v_{q-2}$, qui s'identifient aux couples $v_{M-1}$ et $v_{M-2}$ à partir desquels sont calculées chaque fois les valeurs de Y(k), selon la relation (48), Y(k) étant un nombre complexe dont on peut extraire le module et surtout l'argument φ qu'il est intéressant de connaître au premier chef. Ce calcul, que l'homme du métier est à même de programmer, est effectué par le microprocesseur TMS 32010 et chaque valeur de φ, dite $\varphi_{ref}$ est ensuite transférée par le bus de données selon un certain protocole à une mémoire FIFO constituant des deuxièmes moyens de stockage, dite mémoire FIFO résultats. En associant (de façon non représentée) une mémoire FIFO commandes disposée en parallèle par rapport à la mémoire FIFO résultats sur le bus de données on peut créer un élément de mémoire tampon entre le TMS 32010 utilisé en tant que microprocesseur esclave et un autre microprocesseur utilisé comme microprocesseur maître, un 6809 de MOTOROLA par exemple, ce dernier synchronisé sur le TMS 32010, étant à même d'exploiter les résultats contenus dans la mémoire FIFO résultats et effectuant aussi des tâches de gestion qui sortent du cadre de l'invention. L'information disponible à l'étiquette "ERREUR" est transmise, par l'intermédiaire de la FIFO résultats au microprocesseur maître qui décide alors de la modification éventuelle des valeurs des seuils $s_1$ ou $s_2$ ou de l'amplification accrue à donner au signal analogique d'entrée ou encore d'une temporisation prédéterminée à respecter avant la reprise des calculs que doit effectuer le discriminateur 5.

On a vu ci-dessus, en référence à la figure 1, qu'en présence d'un signal d'entrée trop fortement bruité il était avantageux d'introduire un préfiltrage au moyen d'un filtre d'entrée 6. La mise en circuit du filtre 6 peut être commandée par un signal approprié sur le conducteur 4 à partir du microprocesseur TMS 32010 lui-même, ce qui est représenté à la figure 1 par la ligne en trait interrompu 11; au lieu de la valeur du rapport S/B on peut utiliser une valeur représentative de la puissance de bruit $\sigma^2$ et actionner le commutateur 3 dans la position représentée à la figure 1 lorsque cette valeur représentative dépasse un certain seuil S'' à déterminer lors du test de l'appareillage. Comme grandeur représentative de $\sigma^2$ on choisit la relation (24):

$$\sigma^2 = \frac{1}{N} (R_0 + a_1 R_{01} + a_2 R_{02}) \tag{49}$$

Pour $R_0$ on peut utiliser indifféremment le coefficient $R_{11}$ ou le coefficient $R_{22}$ et, pour effectuer le calcul conforme à la relation (49), on doit préalablement emmagasiner les quantités $a_1$ et $a_2$ dans des emplacements mémoire du microprocesseur qui leur sont propres.

Pour le calcul final de la phase du signal à discriminer on peut utiliser d'autres méthodes numériques que celle de la TFD récursive, telle une méthode à moindres carrés par exemple.

Annexe

Sous sa forme la plus générale, la relation (1) s'écrit:

$$y(t) = c + a \sin(\omega t + \varphi) + b_t \qquad (50)$$

où

t: instant d'arrivée de l'échantillon
c: composante continue
$b_t$: bruit additiv à moyenne nulle.

Sous forme vectorielle, la relation (50) s'écrit:

$$y(t) = \begin{bmatrix} 1 & \sin\omega t & \cos\omega t \end{bmatrix} \times \begin{bmatrix} c \\ a\cos\varphi \\ a\sin\varphi \end{bmatrix} + b_t \qquad (51)$$

ou encore :

$$y_t = H_t\, X + b_t$$

avec :
$$H_t = \begin{bmatrix} 1 & \sin\omega t & \cos\omega t \end{bmatrix}$$

et
$$X = \begin{bmatrix} c & a\cos\varphi & a\sin\varphi \end{bmatrix}^T$$

Le problème consiste à estimer les quantités c, a et $\varphi$, c'est-à-dire le vecteur X sous l'hypothèse de stationnarité ou de pseudo stationnarité.

En multipliant les deux membres de l'équation (51) par $H_t^T$, on obtient:

$$H_t^T\, y_t = H_t^T\, H_t\, X + H_t^T\, b_n$$

En accumulant sur M points:

$$\sum_{t=0}^{M-1} H_t^T\, y_t = \sum_{t=0}^{M-1} H_t^T\, H_t\, X + \sum_{t=0}^{M-1} H_t^T\, b_n$$

le bruit $b_n$, étant à moyenne nulle et décorrélé des termes en $\sin\omega t$ et $\cos\omega t$, peut être négligé et on aboutit à:

$$\sum_{t=0}^{M-1} H_t^T\, y_t = P\, X \qquad\qquad P = \sum_{t=0}^{M-1} H_t^T\, H_t$$

étant une matrice carrée symétrique, et:

$$X = P^{-1}\, Z$$

$$\text{avec } Z = \sum_{t=0}^{M-1} H_t^T\, y_t.$$

On peut alors extraire a et $\varphi$ en calculant P et Z et en résolvant l'équation matricielle:

$$x = P^{-1}\, Z$$

On notera que dans l'hypothèse d'une distribution équirépartie ou régulière des instants d'observation $t_q$ et d'une durée d'observation $T_1$ multiple de la période T du signal analysé ($T = 2\Pi/\omega$), on peut montrer que la matrice P tend vers une matrice diagonale:

$$P = \begin{bmatrix} M & 0 & 0 \\ 0 & M/2 & 0 \\ 0 & 0 & M/2 \end{bmatrix}$$

En considérant l'intervalle entre échantillons comme constant, pour M points régulièrement espacés sur l'intervalle $T_1$, l'expression des instants d'échantillonnage $t_q$ devient:

$$t_q = q(T_1/M)$$

Le vecteur colonne Z s'écrit alors:

$$Z = \begin{bmatrix} \displaystyle\sum_{q=0}^{M-1} y(q\tfrac{T_1}{M}) \\[2ex] \displaystyle\sum_{q=0}^{M-1} y(q\tfrac{T_1}{M})\ \sin\omega q\ \tfrac{T_1}{M} \\[2ex] \displaystyle\sum_{q=0}^{M-1} y(q\tfrac{T_1}{M})\ \cos\omega q\ \tfrac{T_1}{M} \end{bmatrix}$$

La durée d'observation étant multiple de la période de la composante que l'on veut estimer, on peut écrire:

$$T_1 = kT = k\ 2\Pi/\omega$$

k étant un facteur multiplicatif entier.
Z s'écrit alors:

$$Z = \begin{bmatrix} \displaystyle\sum_{q=0}^{M-1} y(q\tfrac{T_1}{M}) \\[2ex] \displaystyle\sum_{q=0}^{M-1} y(q\tfrac{T_1}{M})\sin 2\Pi\tfrac{k}{M}q \\[2ex] \displaystyle\sum_{q=0}^{M-1} y(q\tfrac{T_1}{M})\cos 2\Pi\tfrac{k}{M}q \end{bmatrix} = \begin{bmatrix} Y(0) \\[2ex] \dfrac{1}{2j}\{Y(-k) - Y(k)\} \\[2ex] \dfrac{1}{2}\{Y(-k) + Y(k)\} \end{bmatrix} \qquad (53)$$

Y(k) désigne la TFD (Transformée de Fourier Discrète) de la suite $y((q\ T_1/M)$ pour q allant de 0 à M—1.
La relation (52) devient:

19

$$X = \frac{1}{M}\begin{bmatrix} 1 & 0 & 0 \\ 0 & 2 & 0 \\ 0 & 0 & 2 \end{bmatrix} \times \begin{bmatrix} Y(0) \\ 1/2j\{Y(-k) - Y(k)\} \\ 1/2\{Y(-k) + Y(k)\} \end{bmatrix}$$

ou encore :

$$X = \begin{bmatrix} \dfrac{Y(0)}{M} \\ \dfrac{1}{M} \times \dfrac{1}{j}\{Y(-k) - Y(k)\} \\ \dfrac{1}{M} \times \{Y(-k) + Y(k)\} \end{bmatrix}$$

Le calcul de X se résume donc à la connaissance des raies d'ordre 0 et k de la TFD sur la suite $y(q\,T_1/M)$. Pour trouver le nombre complexe Y(k) on utilise de préférence une méthode de TFD récursive. On notera que la connaissance de Y(k) est suffisante pour estimer le vecteur X. En effet, on peut écrire:

$$|Y(k)| = |Y(-k)|$$
$$\text{et Arg } Y(-k) = -\text{Arg } Y(k)$$

ceci revient à dire qu'au facteur multiplicatif 2/M près on a:

$$|Y(k)| = a$$
$$\text{et Arg } Y(k) = \varphi - \frac{\Pi}{2}$$

Le problème se résume à estimer Y(k) tel que:

$$Y(k) = \sum_{q=0}^{M-1} y\left(q\,\frac{T_1}{M}\right) e^{-j2\Pi\frac{qk}{M}}$$

Pour faciliter l'écriture, on pose:

$$y(q) \equiv y(q\,T_1/M)$$
$$W \equiv e^{-j2\Pi\frac{k}{M}}$$

d'où : 
$$Y(k) = \sum_{q=0}^{M-1} y(q)\,W^q$$

On remarque que Y(k) est un polynôme en puissances de W dont les coefficients sont les échantillons du signal reçu.

On décompose Y(k) de façon à faire apparaître les différents échantillons de la suite $y(0), y(1), \ldots, y(q), \ldots, y(M-1)$. On pose:

$$z(0) = y(0)$$
$$z_q = z_{q-1} \times W^{-1} + y(q)$$
$$\theta = 2k\frac{\Pi}{M} \quad (\text{d'où : } W = e^{-j\theta})$$

$$z_q = v_q - e^{-j\theta}\,v_{q-1}$$

Tous calculs faits, on en déduit:

$$v_q = y(q) + 2 \cos\theta \; v_{q-1} - v_{q-2}$$

$$\text{avec :} \qquad v_{-1} = 0 \quad \text{et} \quad v_{-2} = 0$$

$$Y(k) = e^{j\theta} v_{M-1} - v_{M-2}$$

On obtient finalement l'algorithme suivant:

initialisation:

$v_{-1} = 0$

$v_{-2} = 0$

à chaque échantillon reçu y(q):

$$v_q = y(q) + 2 \cos\left(2k\frac{\Pi}{M}\right) v_{q-1} - v_{q-2} \qquad \text{(valeur réelle)}$$

à la fin de la séquence d'observations:

$$Y(k) = e^{+j2\Pi \frac{k}{M}} v_{M-1} - v_{M-2} \qquad \text{(valeur complexe)}$$

On remarquera que la réduction du nombre d'opérations par rapport à la TFD classique renforce la possibilité d'un calcul dit: en ligne, c'est-à-dire inséré dans les intervalles de temps entre échantillons. Cela permet dès la réception du dernier échantillon (d'ordre M—1) d'obtenir dans un bref délai la valeur de y(k) associée aux M échantillons précédents. D'autre part, ce calcul en ligne s'accompagne d'une réduction notable des mémoires nécessaires au calcul. Cette réduction est encore plus importante dans ce cas que dans d'autres méthodes récursives, vu le faible nombre de variables.

## Revendications

1. Discriminateur numérique de fréquence destiné à extraire d'une porteuse à la fréquence $f_o$ au moins un signal sinusoïdal basse fréquence, de fréquence F, modulant en fréquence ladite porteuse avec une excursion de fréquence modulante $\Delta F$, les valeurs de $f_o$, F et $\Delta F$ étant connues, caractérisé en ce qu'il reçoit, avec ou sans préfiltrage, des échantillons numériques $x_n$ de ladite porteuse modulée à une fréquence $f_e$ telle que $f_e = 4f_o$, et qu'il comporte:

des moyens d'accumulation pour accumuler entre deux dates successives $t_q$ et $t_{q+1}$ un nombre paramétrable de N échantillons numériques $x_n$ successifs qui constituent une fenêtre d'analyse, la fréquence du signal modulé étant considérée constante dans cet intervalle,

des premiers moyens de stockage pour stocker des coefficients $R_{01}$, $R_{02}$, $R_{11}$, $R_{12}$, $R_{22}$ définis par:

$$R_{01} = \sum_{n=0}^{N-1} x_n \cdot x_{n-1}$$

$$R_{02} = \sum_{n=0}^{N-1} x_n \cdot x_{n-2}$$

$$R_{11} = \sum_{n=0}^{N-1} x^2_{n-1}$$

$$R_{12} = \sum_{n=0}^{N-1} x_{n-1} \cdot x_{n-2}$$

$$R_{22} = \sum_{n=0}^{N-1} x^2_{n-2}$$

des moyens de formatage desdits coefficients,

des premiers moyens de calcul de la quantité $a_1$ définie par:

21

$$a_1 = \frac{R_{02}\,R_{12} - R_{01}\,R_{22}}{R_{11}\,R_{22} - R_{12}^2},$$

la quantité $a_1$ étant assimilable, à un coefficient multiplicatif près, à l'ordonnée d'un point de la courbe représentative dudit signal sinusoïdal basse fréquence cherché et que la valeur de $a_1$ est transférée dans des deuxièmes moyens de stockage, après quoi le point suivant dudit signal sinusoïdal basse fréquence est déterminé à partir des N échantillons qui suivent la date $t_{q+1}$.

2. Discriminateur numérique de fréquence selon la revendication 1, caractérisé en ce qu'il comporte en outre des deuxièmes moyens de calcul de la quantité $a_2$ définie par:

$$a_2 = \frac{R_{01}\,R_{12} - R_{02}\,R_{11}}{R_{11}\,R_{22} - R_{12}^2},$$

la quantité $a_2$ étant utilisée comme indicateur de la convergence et qu'à cet effet ledit discriminateur numérique de fréquence comporte des moyens de comparaison de la quantité $a_2$ à deux seuils $s_1$ et $s_2$ de valeurs paramétrables tels que la quantité $a_1$, respectivement $a_1/\sqrt{a_2}$, n'est validée et transférée dans lesdits moyens de stockage que si: $s_1 < a_2 < s_2$.

3. Discriminateur numérique de fréquence selon la revendication 2, caractérisé en ce qu'il comporte en outre des troisièmes moyens de calcul de la quantité $\sigma^2$ représentative de la puissance de bruit du signal échantillonné et définie par:

$$\sigma^2 = \frac{1}{N}\,(R_0 + a_1 R_{01} + a_2 R_{02})$$

4. Discriminateur numérique de fréquence selon l'une des revendications 1 à 3, caractérisé en ce que lorsque la puissance de bruit de la porteuse modulée est détectée comme étant inférieure à un seuil S'' qui correspond à une valeur du rapport signal à bruit de l'ordre de 15 dB, il comporte à son entrée des moyens pour commuter un filtre numérique qui effectue un préfiltrage passe-bande desdits échantillons numériques $(e_n)$, centré sur la fréquence $f_o$.

5. Discriminateur numérique de fréquence selon la revendication 4, caractérisé en ce que ledit filtre numérique effectue un filtrage élémentaire passe-bande du type:

$$x_n = \frac{1}{8}\,(e_n - e_{n-2} + e_{n-4} - e_{n-6} + e_{n-8} - e_{n-10} + e_{n-12} - e_{n-14})$$

équation dans laquelle $e_n$ à $e_{n-14}$ désignent les échantillons numériques de la porteuse.

6. Discriminateur numérique de fréquence selon l'une des revendications 1 à 5, caractérisé en ce qu'il comporte des quatrièmes moyens de calcul de la quantité:

$$v_q = a_{1q} + 2\cos 2k\,\frac{\Pi}{M}\,v_{q-1} - v_{q-2},$$

expression dans laquelle la quantité $a_{1q}/\sqrt{a_{2q}}$ peut être substituée à $a_{1q}$, avec:

$$v_{-2} = v_{-1} = 0,$$

l'indice q variant de 0 à M—1,
et k et M étant des nombres entiers positifs tels que:

$$\frac{k}{M} = \frac{F \times N}{f_e}$$

7. Application du discriminateur numérique de fréquence selon l'une des revendications 1 à 6 à la recherche de la phase dite de référence contenue dans le signal composite VOR reçu par un équipement de bord VOR-ILS, par reconstitution point par point du signal sinusoïdal à 30 Hz donnant la phase de référence, caractérisée par une fréquence d'échantillonnage égale à 39840 Hz, soit quatre fois la fréquence de la porteuse à 9960 Hz modulée en fréquence avec une excursion de 480 Hz par le signal 30 Hz donnant la phase de référence.

8. Application du discriminateur numérique de fréquence selon l'une des revendications 1 à 6 à la recherche de la phase dite de référence contenue dans le signal composite VOR reçu par un équipement de bord VOR-ILS, par reconstitution point par point du signal sinusoïdal à 30 Hz donnant la phase de référence, caractérisée par une fréquence d'échantillonnage, égale à 13280 Hz, appliquée à une porteuse à 3320 Hz obtenue du fait de filtrer la porteuse à 9960 Hz du signal VOR à travers un filtre antirepliement analogique d'ordre inférieur ou égal à trois dont la bande passante est comprise entre 0 et 10600 Hz et dont la bande de transition s'étend entre 10600 Hz et 15960 Hz, d'échantillonner à la fréquence 26560 Hz le signal obtenu en sortie du filtre antirepliement et de filtrer les échantillons à travers un filtre demi-bande à 4 coefficients distincts dont la sortie passe haut est reliée à l'entrée dudit discriminateur numérique.

**Patentansprüche**

1. Digitaler Frequenzdiskriminator zum Extrahieren wenigstens eines sinusförmigen Niederfrequenzsignals mit der Frequenz F aus einem Träger mit der Frequenz $f_o$, welches Niederfrequenzsignal der genannten Träger mit einer modulierenden Frequenzschwingung $\Delta F$ frequenzmoduliert, wobei die Werte von $f_o$, F und $\Delta F$ bekannt sind, dadurch gekennzeichnet, daß er mit oder ohne Vorfilterung digitale Abtastwerte $x_n$ des genannten Trägers erhält, die derart mit einer Frequenz $f_e$ moduliert sind, daß $f_e = 4f_o$ ist und daß er die folgenden Elemente aufweist:

Akkumulationsmittel zum zwischen zwei aufeinanderfolgenden Daten $t_q$ und $t_{q+1}$ Akkumulieren einer parametrisierbaren Anzahl N aufeinanderfolgender digitaler Abtastwerte $x_n$, die ein Analysenfenster bilden, wobei die Frequenz des modulierten Signals in diesem Intervall als konstant betrachtet wird,

erste Speichermittel zum Speichern von Koeffizienten $R_{01}$, $R_{01}$, $R_{11}$, $R_{12}$, $R_{22}$, die wie folgt definiert sind:

$$R_{01} = \sum_{n = 0}^{N - 1} x_n \cdot x_{n-1}$$

$$R_{02} = \sum_{n = 0}^{N - 1} x_n \cdot x_{n-2}$$

$$R_{11} = \sum_{n = 0}^{N - 1} x^2_{n-1}$$

$$R_{12} = \sum_{n = 0}^{N - 1} x_{n-1} \cdot x_{n-2}$$

$$R_{22} = \sum_{n = 0}^{N - 1} x^2_{n-2}$$

Mittel zum Formatieren der genannten Koeffizienten,
erste Mittel zum Berechnen der Größe $a_1$, die wie folgt definiert ist:

$$a_1 = \frac{R_{02} R_{12} - R_{01} R_{22}}{R_{11} R_{22} - R^2_{12}},$$

wobei die Größe $a_1$ zugeordnet ist, bis auf einen multiplikativen Koeffizienten, an die Ordinate eines Punktes auf der Kurve, die das gesuchte niederfrequente sinusförmige Signal darstellt, und daß der Wert von $a_1$ in zweite Speichermittel übertragen wird, wonach aus den N Abtastwerten, die dem Datum $t_{q+1}$ folgen, der nächste Punkt des genannten niederfrequenten sinusförmigen Signals bestimmt wird.

2. Digitaler Frequenzdiskriminator nach Anspruch 1, dadurch gekennzeichnet, daß er ebenfalls zweite Mittel zum Berechnen der Größe $a_2$ aufweist, die wie folgt definiert ist:

$$a_2 = \frac{R_{01} R_{12} - R_{02} R_{11}}{R_{11} R_{22} - R_{12}^2},$$

wobei die Größe $a_2$ als Konvergenzanzeige verwendet wird wozu der genannte digitale Frequenzdiskriminator Mittel zum Vergleichen der Größe $a_2$ mit zwei Schwellen $s_1$ und $s_2$, deren Werte derart parametrisierbar sind, daß die Größe $a_1$ bzw. $a_1/\sqrt{a_2}$ nur dann bewertet und in die genannten zweiten Speichermittel übertragen wird, wenn $s_1 < a_2 < s_2$ ist.

3. Digitaler Frequenzdiskriminator nach Anspruch 2, dadurch gekennzeichnet, daß er außerdem dritte Mittel zum Berechnen der Größe $\sigma^2$ aufweist, welche die Rauschleistung des abgetasteten Signals darstellt und wie folgt definiert ist:

$$\sigma^2 = \frac{1}{N} (R_0 + a_1 R_{01} + a_2 R_{02})$$

4. Digitaler Frequenzdiskriminator nach einem der Ansprüche 1 bis 3, dadurch gekennzeichnet, daß er, wenn detektiert wird, dass die Rauschleistung des modulierten Trägers niedriger ist als eine Schwelle $S''$, die einem Wert des Rauschabstandes in der Größenordnung von 15 dB entspricht, an dem Eingang Mittel zum Einschalten eines digitalen Filters aufweist, das eine um die Frequenz $f_0$ zentrierte Bandpass-Vorfilterung der genannten digitalen Abtastwerte $(e_n)$ durchführt.

5. Digitaler Frequenzdiskriminator nach Anspruch 4, dadurch gekennzeichnet, daß das digitale Filter eine elementäre Bandpass-Filterung vom nachfolgenden Typ durchführt:

$$x_n = 1/8 (e_n - e_{n-2} + e_{n-4} - e_{n-6} + e_{n-8} - e_{n-10} + e_{n-12} - e_{n-14}),$$

wobei in dieser Gleichung $e_n$ bis $e_{n-14}$ die digitalen Abtastwerte des Trägers darstellen.

6. Digitaler Frequenzdiskriminator nach einem der Ansprüche 1 bis 5, dadurch gekennzeichnet, daß er vierte Mittel zum Berechnen der nachfolgenden Größe aufweist:

$$v_q = a_{1q} + 2 \cos 2k(\Pi/M)v_{q-1} - v_{q-2},$$

wobei in diesem Ausdruck die Größe $a_{1q}/\sqrt{a_{2q}}$ durch $a_{1q}$ ersetzt werden kann, mit:

$$v_{-2} = v_{-1} = 0,$$

wobei der Index q von 0 bis M—1 variieren kann,
und k und M ganze positive Zahlen sind, derart, daß:

$$\frac{k}{M} = \frac{F \times N}{f_e} \quad \text{ist.}$$

7. Gebrauch des digitalen Frequenzdiskriminators nach einem der Ansprüche 1 bis 6, zum Suchen der als Bezugsphase bekannten Phase in dem mit einer VOR-ILS-Bord-Anordnung empfangenen zusammengesetzten VOR-Signal durch punktweise Rekonstruktion des sinusförmigen 30 Hz-Signals, das die Bezugsphase gibt, gekennzeichnet durch eine Abtastfrequenz gleich 39840 Hz, die der vierfachen Trägerfrequenz von 9960 Hz entspricht, die mittels des 30 Hz-Signals mit einem Hub von 480 Hz frequenzmoduliert ist, das die Bezugsphase gibt.

8. Gebrauch des digitalen Frequenzdiskriminators nach einem der Ansprüche 1 bis 6, zum Suchen der als Bezugsphase bekannten Phase in dem mit einer VOR-ILS-Bord-Anordnung empfangenen zusammengesetzten VOR-Signal durch punktweise Rekonstruktion des sinusförmigen 30 Hz-Signals, das die Bezugsphase gibt, gekennzeichnet durch eine Abtastfrequenz gleich 13280 Hz, die einem Träger von 3320 Hz aufgeprägt ist, der erhalten worden ist durch Filterung des Trägers von 9960 Hz des VOR-Signals mittels eines analogen Anti-Aliassing-Filters in der Größenordnung von kleiner als drei oder gleich drei, dessen Durchlassbereich zwischen 0 und 10600 Hz liegt und dessen Übergangsbereich sich zwischen 10600 Hz und 15960 Hz erstreckt, und durch Abtastung mit einer Frequenz von 26560 Hz des Signals, das an dem Ausgang des Anti-Aliassing-Filters erhalten worden ist und durch Filterung der Abtastwerte mittels eines Halbbandfilters mit 4 spezifischen Koeffizienten, dessen Hochpassausgang mit dem Eingang des genannten Digitalen Diskriminators verbunden ist.

## EP 0 224 315 B1

**Claims**

1. Digital frequency discriminator intended for extracting from a carrier at a frequency of $f_o$ at least one low-frequency sinusoidal signal, of frequency F, frequency modulating said carrier with a modulating frequency excursion $\Delta F$, the values of $f_o$, and $\Delta F$ being known, characterised in that it receives, with or without pre-filtering, digital samples $x_n$ of said carrier modulated at a frequency $f_e$ such that $f_e = 4f_o$, and in that it includes:

means of accumulation for accumulating between two successive dates $t_q$ and $t_{q+1}$ a number N, which can be set, of successive digital samples $x_n$ which form an analysis window, the frequency of the modulated signal being considered constant during this interval,

first means of storage for storing coefficients $R_{01}$, $R_{02}$, $R_{11}$, $R_{12}$ and $R_{22}$ defined by:

$$R_{01} = \sum_{n=0}^{N-1} x_n \cdot x_{n-1}$$

$$R_{02} = \sum_{n=0}^{N-1} x_n \cdot x_{n-2}$$

$$R_{11} = \sum_{n=0}^{N-1} x^2_{n-1}$$

$$R_{12} = \sum_{n=0}^{N-1} x_{n-1} \cdot x_{n-2}$$

$$R_{22} = \sum_{n=0}^{N-1} x^2_{n-2}$$

means for formatting said coefficients,

first means of computing the quantity $a_1$ defined by:

$$a_1 = \frac{R_{02} R_{12} - R_{01} R_{22}}{R_{11} R_{22} - R^2_{12}},$$

the quantity $a_1$ being similar, to the nearest multiplicative coefficient, to the ordinate of a point on the curve representing said searched low frequency sinusoidal signal and in that the value of $a_1$ is transferred into second means of storage, after which the next point of the said low frequency sinusoidal signal is determined from the N samples which follow the data $t_{q+1}$.

2. Digital frequency discriminator according to Claim 1, characterised in that it also includes second means of computing the quantity $a_2$ defined by:

$$a_2 = \frac{R_{01} R_{12} - R_{02} R_{11}}{R_{11} R_{22} - R_{12}^2},$$

the quantity $a_2$ being used as a convergence indicator and for this purpose the said digital frequency discriminator includes means of comparison of the quantity $a_2$ with two thresholds $s_1$ and $s_2$ whose values can be set such that the quantity $a_1$, respectively $a_1/\sqrt{a_2}$, is only validated and transferred into the said second means of storage if: $s_1 < a_2 < s_2$.

25

3. Digital frequency discriminator according to Claim 2, characterised in that it also includes third means of computing the quantity $\sigma^2$ representing the noise power of the samples signal and defined by:

$$\sigma^2 = \frac{1}{N} (R_0 + a_1 R_{01} + a_2 R_{02})$$

4. Digital frequency discriminator according to one of Claims 1 to 3, characterised in that when the noise power of the modulated carrier is detected as being lower than a threshold S'' which corresponds to a value of the signal-to-noise ratio of the order of 15 dB, it includes at its input means for switching a digital filter which carries out a band pass prefiltering of the said digital samples $(e_n)$, centred on the frequency $f_o$.

5. Digital frequency discriminator according to Claim 4, characterized in that the said digital filter carries out an elementary band pass filtering of the type:

$$x_n = 1/8 (e_n - e_{n-2} + e_{n-4} - e_{n-6} + e_{n-8} - e_{n-10} + e_{n-12} - e_{n-14}),$$

an equation in which $e_n$ to $e_{n-14}$ designate the digital samples of the carrier.

6. Digital frequency discriminator according to one of Claims 1 to 5, characterised in that it includes fourth means of computing the quantity:

$$v_q = a_{1q} + 2 \cos 2k \frac{\Pi}{M} v_{q-1} - v_{q-2},$$

an expression in which the quantity $a_{1q}/\sqrt{a_{2q}}$ can be substituted for $a_{1q}$, where:

$$v_{-2} = v_{-1} = 0,$$

the index q varying from 0 to M—1,
and k and M being positive integers such that:

$$\frac{k}{M} = \frac{F \times N}{f_e}$$

7. Use of the digital frequency discriminator according to one of Claims 1 to 6 to the search for the phase known as the reference phase contained in the composite VOR signal received by an on-board VOR-ILS equipment, by point by point restoration of the 30 Hz sinusoidal signal giving the reference phase, characterised by a sampling frequency equal to 39840 Hz, which is four times the frequency of the carrier at 9960 Hz frequency modulated with a 480 Hz excursion by the 30 Hz signal giving the reference phase.

8. Use of the digital frequency discriminator according to one of Claims 1 to 6 to the search for the phase known as the reference phase contained in the composite VOR signal, received by an on board VOR-ILS equipment, by point by point restoration of the 30 Hz sinusoidal signal giving the reference phase, characterised by a sampling frequency, equal to 13280 Hz, applied to a carrier of 3320 Hz obtained by filtering the 9960 Hz carrier of the VOR signal through an analog one-way filter of order less than or equal to three whose pass band is between 0 and 10600 Hz and whose transition band extends between 10600 Hz and 15960 Hz, by sampling the signal obtained at the output of the one-way filter at a frequency of 26560 Hz and by filtering the samples through a half-band filter with 4 distinct coefficients whose high pass output is connected to the input of the said digital discriminator.

FIG.1

FIG.2

FIG.3

FIG.4

FIG.6

FIG.5

FIG.7

FIG.8a

FIG. 8b

FIG. 9